(19) Europäisches Patentamt
European Patent Office
Office européen des brevets

(11) **EP 4 372 628 B1**

(12) **EUROPEAN PATENT SPECIFICATION**

(45) Date of publication and mention
of the grant of the patent:
**29.10.2025 Bulletin 2025/44**

(21) Application number: **22306684.6**

(22) Date of filing: **16.11.2022**

(51) International Patent Classification (IPC):
***G06N 10/40*** *(2022.01)* ***G06N 10/70*** *(2022.01)*

(52) Cooperative Patent Classification (CPC):
**G06N 10/40; G06N 10/70**

(54) **DEVICE FOR A RESONANT CAT-QUBIT CIRCUIT AND QUANTUM MEASUREMENT METHOD**

VORRICHTUNG FÜR EINE RESONANTE CAT-QUBIT-SCHALTUNG UND QUANTENMESSVERFAHREN

DISPOSITIF POUR CIRCUIT À QUBIT CAT RÉSONANT ET PROCÉDÉ DE MESURE QUANTIQUE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**22.05.2024 Bulletin 2024/21**

(73) Proprietor: **Alice & Bob**
**75015 Paris (FR)**

(72) Inventors:
• **ESSIG, Antoine**
**75015 Paris (FR)**
• **COTTET, Nathanaël**
**75015 Paris (FR)**
• **LESCANNE, Raphaël**
**75015 Paris (FR)**

(74) Representative: **Cabinet Netter**
**36, avenue Hoche**
**75008 Paris (FR)**

(56) References cited:
**WO-A1-2017/158134**

• **RONAN GAUTIER ET AL: "Combined Dissipative and Hamiltonian Confinement of Cat Qubits", ARXIV.ORG, CORNELL UNIVERSITY LIBRARY, 201 OLIN LIBRARY CORNELL UNIVERSITY ITHACA, NY 14853, 17 February 2022 (2022-02-17), XP091147469**
• **ZLATKO K MINEV ET AL: "Energy-participation quantization of Josephson circuits", ARXIV.ORG, CORNELL UNIVERSITY LIBRARY, 201 OLIN LIBRARY CORNELL UNIVERSITY ITHACA, NY 14853, 15 February 2021 (2021-02-15), XP081879649**
• **J\'ER\'EMIE GUILLAUD ET AL: "Quantum computation with cat qubits", ARXIV.ORG, CORNELL UNIVERSITY LIBRARY, 201 OLIN LIBRARY CORNELL UNIVERSITY ITHACA, NY 14853, 25 August 2022 (2022-08-25), XP091301867**
• **ANTOINE ESSIG ET AL: "Multiplexed photon number measurement", ARXIV.ORG, CORNELL UNIVERSITY LIBRARY, 201 OLIN LIBRARY CORNELL UNIVERSITY ITHACA, NY 14853, 9 January 2020 (2020-01-09), XP081575997**

**Description**

The present disclosure relates to the field of quantum technologies, and more specifically to a method for measuring qubits in a superconducting quantum circuit.

There has been growing attention in recent years for developing quantum technologies for several applications, such as quantum computation and communication. Superconducting quantum circuits are a promising platform to realize quantum computer and among them the so-called cat-qubits that are stored in superconducting resonators are one interesting candidate.

A cat-qubit is defined as a specifically selected two-dimensional sub-manifold of a main manifold spanned by several coherent states. As an example, the two-component cat-qubit main manifold is the span of two coherent states with equal amplitude and opposite phase; the main manifold being two-dimensional, in that case the sub-manifold is equal to the main manifold. As another example, the four-component cat-qubit main manifold is the span of four coherent states with equal amplitudes and phases shifted by 90° from one another. The two-dimensional sub-manifold is chosen as even photon number parity sub-manifold. To generalize, 2N-component cat-qubit main-manifold is the span of 2N coherent states with equal amplitudes and phase shifted by $\pi/N$ from one another. The two-dimensional sub-manifold is chosen as the 0 modulo N photon number sub-manifold. An example cat-qubits has been studied in the following article:

- "Combined Dissipative and Hamiltonian Confinement of Cat Qubits", Gautier R. et al, PRX Quantum, 2021.

In this context, superconducting quantum circuits maybe engineered to exhibit specific quantum dynamics, such as stabilizing a quantum manifold of coherent states._The stabilization of a quantum manifold of two coherent states by dissipation has been studied notably in the following articles:

- "Exponential suppression of bit-flips in a qubit encoded in an oscillator", Lescanne R. et. al., Nature Physics, 2020;
- "Coherent Oscillations inside a Quantum Manifold Stabilized by Dissipation", Touzard S. et. al.; Physical Review X, 2018; and
- "Confining the state of light to a quantum manifold by engineered two-photon loss". Leghtas Z. et. al., Science, 2015.

The stabilization of 2N coherent states requires to engineer a non-linear conversion between 2N-photons of a first mode that hosts the stabilized quantum manifold, this mode is also called the cat-qubit mode and one photon of a second mode known as buffer mode and conversely. To achieve the non-linear conversion, existing solutions comprise applying external time-varying excitations on the superconducting quantum circuit, in the form of one or more microwave tones at specific frequencies called parametric pumps so as to bridge the energy gap between the energy of 2N photons of the first mode and one photon of the second mode. These solutions are also known as parametric pumping techniques.

The Applicant has disclosed in patent application EP21306965.1 a family of superconducting quantum circuits in which the resonant frequency of the second mode is substantially 2N times the resonant frequency of the first mode when a predetermined current of a constant intensity is applied to the circuit. This provides for what will be hereinafter referred to as "resonant cat-qubit circuits" and "resonant cat-qubits", as the 2N-to-1 photon conversion does not require parametric pumping to bridge the energy gap of the process. Once this non-linear conversion process is enabled, the coherent state manifold is stabilized by coupling the second mode (or "buffer mode") to an environment comprising a microwave source that drives it at resonance and a load that makes the second mode dissipative. This single-photon drive gets converted into a 2N-photon drive on the first mode or cat-qubit mode by the non-linear conversion process. In the same manner, the single-photon loss gets converted into 2N-photon loss on the cat-qubit mode.

While allowing to forego the use of parametric pumping techniques is extremely advantageous, the implementation of the resonant cat-qubit circuits introduces new challenges in the measurement of the cat-qubits.

In previous implementations, the state of the cat-qubit mode is determined by measuring the Wigner function. This measurement is most often based on the dispersive interaction between the cat-qubit mode and a two-level system. The dispersive interaction embedded within a Ramsey sequence on the two-level system enables to measure the parity of the field. Conventional Wigner function measurement in the context of superconducting circuits is described in the article by Sun, L., Petrenko, A., Leghtas, Z. et al. "Tracking photon jumps with repeated quantum non-demolition parity measurements", Nature 511, 444-448 (2014), https://doi.org/10.1038/nature13436.

Dispersive coupling is inhibited by the coherent states stabilization. Hence the Wigner function cannot be measured while the main manifold is stabilized. In previous implementations of stabilized cat-qubits involving parametric pumping techniques, the Wigner function is measured after the stabilization process is neutralized by turning off the parametric pump that enables the 2N-to-1 photon conversion between the cat-qubit mode and the buffer mode. This can be done almost instantaneously (tens of ns) thanks to the large bandwidth of the microwave lines.

This is however not possible in the context of resonant cat-qubits. Indeed, since the stabilization is self-sustaining, there is no parametric pump to turn-off.

A solution could be to use a magnetic field to detune the resonant frequencies of the resonant cat-qubit circuit in order to deactivate the 2N-to-1 photon conversion between the cat-qubit mode and the buffer mode. However, there is currently no known manner to provide such magnetic field fast enough given the constraints of the resonant cat-qubit circuit.

The invention aims at improving the situation. To that end, the Applicant provides a quantum device comprising:

- a non-linear superconducting quantum circuit having a first mode and a second mode each having a respective resonant frequency and a central mixing component which comprises

    at least one loop that includes a first Josephson junction, a central inductive element, and a second Josephson junction arranged in a series topology substantially symmetrical with respect to an axis which maps the first Josephson junction to the second Josephson junction comprising a first inner node connecting a pole of the first Josephson junction with a pole of the central inductive element, a second inner node connecting a pole of the second Josephson junction with another pole of the inductive element, and a loop-closing node connecting another pole of the first Josephson junction with another pole of the second Josephson junction, a first circuit portion connected between the common ground and the first inner node of the loop, and a second circuit portion between the common ground and the second inner node of the loop, such that said first circuit portion and said second circuit portion are mutually substantially symmetrical with respect to said axis, and a third circuit portion connected between said loop-closing node and the common ground and substantially symmetrical with respect to said axis, said non-linear superconducting quantum circuit being configured such that, when a predetermined current of a constant intensity is applied, the resonant frequency of the second mode is substantially 2N times the resonant frequency of the first mode, a phase difference is induced across the one or more Josephson junctions, such that the non-linear superconducting quantum circuit has an Hamiltonian expandable into a sum between at least a dominant term of the form $\hbar g_{2N} a^{2N} b^{\dagger} + \hbar g_{2N}^{*} a^{\dagger 2N} b$ and a series of subsidiary terms, where $g_{2N}$ is a scalar corresponding to the intrinsic coupling strength, a is the annihilation operator of the first mode, *b* is the annihilation operator of the second mode, and $\hbar$ is the reduced Planck constant, thereby performing intrinsically a resonant 2N-to-1 photon exchange between respectively the first mode and the second mode, N being a positive integer, said non-linear superconducting quantum circuit lying on a dielectric substrate and being delimited from a common ground plane by exposed portions of said dielectric sub strate,

- a flux line located opposite the portion of said at least one loop comprising said central inductive element, comprising a first slot, and a CPW portion,

    said CPW portion being arranged to be coupled to a current source, a microwave source configured to apply a microwave radiation, and a load, and being delimited by an end wire bond, said first slot being patterned within said ground plane exposing said dielectric substrate, extending substantially parallel to said axis, being connected at one end to a slot of said CPW portion at the level of said end wire bond, and at the other end to the exposed dielectric substrate portion delimiting the portion of said at least one loop comprising said central inductive element, said flux line being configured such that it allows the coupling of said current source to induce said predetermined current in said at least one loop, allows coupling of said microwave radiation source to induce a drive of the second mode at a frequency substantially equal to the resonant frequency of the second mode or 2N times the resonant frequency of the first mode, and allows coupling a load substantially exclusively with said second mode.

According to various embodiments, the quantum device may comprise one or more of the following features:

- said flux line further comprises a second slot being patterned within said ground plane exposing said dielectric substrate, extending substantially parallel to said axis, being connected at one end to another slot of said CPW portion at the level of said end wire bond, and ending at the other end within said ground plane at a distance from said portion of said at least one loop comprising said central inductive element which is greater than 1 $\mu$m,
- said second slot comprises a return portion closest to said portion of said at least one loop comprising said central inductive element, said return portion extending substantially orthogonally to said axis in a turning direction away from said first slot,
- said return portion length is greater than 1 $\mu$m and up to the width of the non-linear superconducting circuit,
- said first slot is substantially symmetrical with respect to said axis,

- said first slot and second slot are both offset in a direction orthogonal to said axis and inverse to said turning direction,
- said offset is greater than $1\mu m$ and up to the width of the non-linear superconducting circuit,
- the length of said first slot or alternatively the position of the wire bond is chosen according to the intensity of the coupling intended between said second mode and said load,
- the coupling of said load with said second mode is more than 100 times greater than the coupling of said load with said first mode,
- the device further comprises a current source, a microwave source and a load coupled to said CPW portion operated so as to stabilize a manifold of coherent states in said device,

The invention also concerns a quantum measurement method for a device according as described above comprising:

a) modifying the current output of said current source such that the predetermined current in said non-linear superconducting circuit induces a resonant frequency of the second mode substantially different from 2N times the resonant frequency of the first mode,
b) performing a quantum measurement on the first mode of said non-linear superconducting circuit.

According to various embodiments, the method may comprise one or more of the following features:

- the modifying of operation a) is performed by applying a square pulse to said current,
- operation b) is a quantum nondemolition measurement, and further comprising the following operation: c) restoring the current output of said current source to obtain the predetermined current after operation b) is performed,

The invention also concerns a quantum computing system comprising at least one device according to the invention.
Non-limiting examples will now be described in reference to the accompanying drawings on which:

- Figure 1 illustrates how a resonant cat-qubit circuit is incorporated in a device to stabilize quantum information,
- Figure 2 illustrates various examples of circuits used to isolate the first mode from the environment,
- Figure 3 illustrates examples of how to use the resonant cat-qubit circuit incorporated in a device to stabilize quantum information,
- Figures 4a and 4b illustrate how the current is tuned to reach the frequency matching condition,
- Figure 5 illustrates several examples of circuit symbolic representations alternatively used throughout the specification,
- Figure 6 illustrates an embodiment of the device of Figure 1,
- Figure 7 a general circuit symbolic representation of a resonant cat-qubit circuit used in the device according to the invention,
- Figure 8a illustrates a top view of a device according to the invention comprising a resonant cat-qubit circuit in the absence of a flux line, and Figure 8b represents a circuit symbolic representation of the differential mode of the resonant cat-qubit circuit
- Figure 9a represents a top view of a first embodiment of a device according to the invention, and Figure 9b represents a circuit symbolic representation of the differential mode of the resonant cat-qubit circuit of Figure 9a when the device is operated,
- Figure 10 represents a top view of a second embodiment of a device according to the invention,
- Figure 11 represents a top view of a third embodiment of a device according to the invention,
- Figure 12 represents a top view of a fourth embodiment of a device according to the invention,
- Figure 13 shows a picture of a manufactured device corresponding to the first embodiment, and
- Figure 14 shows a picture of a manufactured device corresponding to the fourth embodiment.

Prior to describing the measurement method according to the invention, the Applicant will describe the resonant cat-qubit and the underlying principles. This will help to better understand the nature of the resonant cat-qubit circuits, why their stabilization is unique and causes unique challenges.
First, the context of the resonant cat-qubit will be explained.
For a resonant cat-qubit to be realized, a non-linear superconducting quantum circuit having a first mode and a second mode is provided. Each of the first mode and the second mode has a respective resonant frequency. The circuit is configured such that the resonant frequency of the second mode is substantially 2N times the resonant frequency of the first mode when a predetermined current of a constant intensity is applied to the circuit. The circuit thus performs intrinsically a resonant 2N-to-1 photon exchange between respectively the first mode and the second mode. N is a positive integer (that is, N is any positive integer larger than or equal to 1), and thus 2N is an even number, e.g., 2, 4, 6 or more. Hence, the expression "2N photons" means a discrete and even quantity of photons defined by the integer 2N.

Such a superconducting quantum circuit improves the resonant 2N-to-1 photon exchange between respectively the first mode and the second mode. Indeed, in the superconducting quantum circuit, the resonant frequency of the second mode is substantially 2N times the resonant frequency of the first mode when a predetermined current of a constant intensity is applied to the circuit. This contrasts with the known dissipation-based cat-qubit realizations, where external time-varying excitations such as those performed by parametric pumping techniques are used to bridge the gap between the frequencies of the two modes and perform the resonant 2N-to-1 photon exchange. The external time-varying excitation used in such prior art relaxes the constraint on the modes frequencies but induces undesired effects such as heating the modes. This heating reduces coherence times of the circuit and causes instabilities of the dynamics. This results in that any non-linear mixing, including the resonant 2N-to-1 photon exchange is ultimately destroyed. In this respect, the absence of external time-varying excitation enables increasing the rate of the resonant 2N-to-1 photon exchange by one or two orders of magnitude compared to prior art.

The first mode and the second mode of the superconducting quantum circuit may each correspond to natural resonance frequencies of the circuit. For example, each of the first mode and the second mode may be either an electromagnetic mode or a mechanical mode. Each of the first mode and the second mode may have a respective natural resonance frequency. For example, the first mode (respectively the second mode) may be a mechanical mode and the second mode may be an electromagnetic mode (respectively the first mode being an electromagnetic mode). The first mechanical mode and the second electromagnetic mode may be coupled in the circuit via piezo-electric effect. Each of the first mode and the second mode may have a respective resonant frequency, e.g., the first mode may have a resonant frequency of the type $f_a = \frac{\omega_a}{2\pi}$ and the second mode may have a resonant frequency of the type $f_b = \frac{\omega_b}{2\pi}$, where $\omega_a$ and $\omega_b$ may be the angular frequencies of each respective mode. By "having" a first mode and a second mode, it is meant that the superconducting quantum circuit may comprise components operating in a superconducting regime which host the modes independently of each other or concurrently. In other words, the first mode and the second mode may be hosted in different subsets of components of the superconducting circuit or (alternatively) on the same subset of components.

The superconducting quantum circuit may be operated at temperatures close to absolute zero (e.g., 100 mK or less, typically 10 mK), and isolated as much as possible from the environment to avoid energy loss and decoherence, except for some tailored couplings. For example, only the second mode may be coupled to a dissipative environment, while the first mode may remain isolated from the environment.

The superconducting quantum circuit may be manufactured as one or more patterned layers of superconducting material (e.g., aluminum, tantalum, niobium among others, as known in the art) deposited on a dielectric substrate (e.g., silicon, sapphire among others). Each of the one or more patterned layers may define lumped element resonators. A capacitive element may be formed (on a respective layer of the one or more patterned layers) with two neighboring plates of superconducting material. An inductive element may be formed with a superconducting wire. Alternatively, at least one of the one or more patterned layers may define portions of transmission lines each resonating at a frequency which depends on their length. The transmission lines may be, for example, co-planar wave guides or microstrip lines. Yet alternatively, the circuit may be embedded in a 3D architecture which comprises high quality 3D modes machined or micro-machined into bulk superconductor that can be used as any of the two modes.

The non-linear circuit and the predetermined current of a constant intensity are configured such that, when said predetermined current is applied to the circuit, the resonant frequency of the second mode of the circuit is substantially 2N times the resonant frequency of the first mode (also called a "frequency matching condition" of the form $2Nf_a = f_b$, $f_a$ being the resonant frequency of the first mode and $f_b$ being the resonant frequency of the second mode, or equivalently of the form $2N\omega_a = \omega_b$). In other words, the predetermined current is an external current which induces an internal DC (direct current) bias to the circuit. The internal current is adapted so that the components/hardware forming the circuit are in a specific regime: namely, that the respective resonant frequency of the second mode - also called second resonant frequency- of the circuit is substantially 2N times the respective resonant frequency of the first mode - also called first resonant frequency. Thus, the non-linearity of the circuit performs intrinsically the resonant 2N-to-1 photon exchange that destroys 2N photons in the first mode at the first resonant frequency while creating one photon in the second mode at the second resonant frequency, and conversely destroys one photon in the second mode at the second resonant frequency while creating 2N photons in the first mode at the first resonant frequency. Indeed, the resonant 2N-to-1 photon exchange may be performed at a given rate, hereinafter denoted $g_{2N}$. The exchange of photons among the two modes may be mediated via elements (e.g., non-linear elements) of the circuit. The predetermined current is applied so that the frequency matching condition of the type $2N\omega_a = \omega_b$ occurs, and so that the circuit performs the resonant 2N-to-1 photon exchange dynamics. The predetermined current at which the frequency matching condition is reached is also called the bias point of the circuit. The bias point may also be called an optimal bias point if the choice of the circuit parameters makes spurious dynamics vanish at the frequency matching condition, as shown in examples below.

The predetermined current may be applied directly - that is, galvanically - to the circuit so that it flows through at least a subset of elements of the circuit and gets divided in the various possible branches. The currents that flow in the branches of the circuit are called internal currents and are determined according to Kirchhoff's current laws. In various examples, the predetermined current may be applied directly via a current source, connected to the circuit. In various examples, the circuit may have a planar geometry, and thus the path of the predetermined current merges with a portion of the superconducting loop in the same planar geometry, e.g., an on-chip current path.

Alternatively, the predetermined current may be applied indirectly, that is, an internal current may be induced in the circuit through a mutual inductance, for example with a coil. In other words, an external inductance is inductively coupled to the circuit via a shared mutual inductance to induce a current in the circuit so that it flows through at least a subset of elements of the circuit. Thus, the internal current is the current induced into the circuit via the mutual inductance. Since there is no need for a direct (galvanic) connection with the circuit, the predetermined current path may be either on the same level as the circuit or made of an external coil above or below the circuit, the axis of which being perpendicular to the superconducting circuit plane. In various examples, when the mutual inductance is shared with a coil, the later may be formed with multiple turns of a material that allows the circulation of current in order to generate of a magnetic field. The coil may be made of any number of coils needed; this increases the mutual inductance. The coil may be made of any material that allows circulation of current to generate a magnetic field and in turn induce the internal current. For instance, the coil may be made of a superconducting material or a non-superconducting material. Alternatively, the coil may be replaced by a permanent magnet that directly generates a constant magnetic field. However, this makes the tuning of the magnetic field unpractical.

The application of the predetermined current results in an internal current $I_{DC}$ which flows through a subset of inductive elements and in superconducting phase drops $\varphi_{DC}$ which develop across each inductive element. The phase drop $\varphi_{DC}$ may be computed given the circuit geometry and parameters as a function of the predetermined current. Examples below illustrate how the predetermined current may be experimentally tuned (or equivalently the superconducting phase-drop $\varphi_{DC}$) to reach the bias point and thereby enable the resonant 2N-to-1 photon exchange dynamics. Thus, the application of the current is adapted to the configuration of the circuit so as to induce the intrinsic resonant 2N-to-1 photon exchange.

The resonant cat-qubit circuit intrinsically performs a resonant 2N-to-1 photon exchange. In other words, the circuit is configured to perform the resonant 2N-to-1 photon exchange autonomously/natively, that is, without requiring an external time-varying excitation to bridge the gap between 2N times the frequency of the first mode and the frequency of the second mode. In other words, the value of the predetermined current is set in such a manner that the components hosting the first and second modes are in a regime allowing the resonant 2N-to-1 photon exchange. There is no dependence on any microwave devices external to the circuit, such as a parametric pump. A resonant 2N-to-1 photon exchange between respectively the first mode and the second mode is a quantum dynamic that destroys 2N photons of the first mode at the respective resonant frequency of the first mode and creates one photon of the second mode at the respective resonant frequency of the second mode and conversely. Said resonant 2N-to-1 photon exchange is performed when the resonant frequency of the second mode is substantially 2N times the frequency of the resonant first mode, by applying the predetermined current of a constant intensity to the circuit. By "substantially", it is meant that the value of the predetermined current is such that the frequency of the second mode is equal to 2N times the frequency of the first mode - also called a frequency matching condition in some applications - up to a predetermined threshold of the same order of magnitude as the resonant 2N-to-1 photon exchange rate $g_{2N}$.

Since the superconducting quantum circuit reliably performs said quantum dynamics intrinsically, the need of a parametric pump is suppressed, and the quality of the resonant 2N-to-1 photon exchange is improved. Indeed, the removal of the parametric pump eliminates the apparition of detrimental parasitic interactions that affect the quality of the resonant 2N-to-1 photon exchange.

The circuit may be integrated into a device which may also comprise a current source configured to apply the predetermined current of a constant intensity to the circuit such that the frequency of the second mode is substantially 2N times the frequency of the first mode. The current source may be directly connected or inductively coupled to the circuit, so that the induced internal current traverses at least some or all of the elements of the circuit. In other words, the applied current may induce an internal current moving through the surface of the circuit, in specific elements of the circuit. The current source is an apparatus that may be placed at room temperature, and thus not comprising superconducting elements. The current source may apply the predetermined current to the circuit first via conducting wires at room temperature, which are in turn connected, as the temperature decreases, to superconducting wires that apply the current to the superconducting circuit. The current may also be filtered using a low pass filter along its path to reduce the impact of low frequency noise.

In various examples, the device may further comprise a load, a microwave source and a coupler. The coupler may be configured to connect the second mode of the superconducting quantum circuit to the load. The load is a dissipative element, e.g., an element with a given resistance - as opposed to a superconducting element - that is external to the superconducting circuit. The load dissipates photons exchanged from the first mode to the second mode through the resonant 2N-to-1 photon exchange. In other words, photons destroyed from the first mode are evacuated through the second mode via the load to the environment. The microwave source may be configured to apply a microwave radiation at a frequency substantially equal to the frequency of the second mode or at a frequency substantially equal to 2N times the frequency of the first mode. In other words, the microwave source may be configured to control the microwave radiation in amplitude and phase. The microwave source thus drives photons in the form of the microwave radiation into the second mode which in turns drives 2N photons in the first mode through the resonant 2N-to-1 photon exchange. The coupler is an element which may be connected galvanically, capacitively or inductively to elements of the circuit hosting the second mode and which mediates the interaction between the second mode, the load and the microwave source.

Optionally, the coupler may also be configured for coupling the elements of the circuit hosting the second mode of the superconducting quantum circuit to the load and to the microwave source.

The load may be a resistor, a matched transmission line or a matched waveguide. The expression "matched" should be interpreted as meaning that the transmission line or the waveguide are terminated by a resistance at an end different from the end connected to the elements hosting the second mode, the value of such resistance being chosen such that the power going towards the load is mostly absorbed. The load may be comprised within the microwave source.

In various examples, this microwave source may be placed a room temperature and connected to the circuit via coaxial cables. In various examples, attenuators may be placed between the microwave source and the circuit - that is, along the path of the microwave radiation applied by the microwave source - to thermalize the microwave radiation with the cryogenic environment. This allows to apply the microwave radiation without added noise. This microwave radiation does not serve the same purpose as a parametric pump and is not required to obtain the resonant 2N-to-1 photon exchange dynamics. Here, the dissipation from the load, the microwave radiation and the resonant 2N-to-1 photon exchange dynamics intrinsically performed by the circuit are used together to stabilize 2N coherent states in the first mode. Indeed, in the absence of microwave radiation, the stable manifold is the manifold spanned by Fock states $\{|0\rangle, |1\rangle\}$. Since the first mode has some residual single photon dissipation, the state $|1\rangle$ decays towards the state $|0\rangle$, and thus only vacuum is stabilized in the long run in the first mode. In other words, the device allows the stabilization of a quantum manifold of coherent states beyond the vacuum.

Optionally, the device may comprise a bandpass or a band stop filter connected to the first mode and the second mode of the circuit. The bandpass or the band stop filter may be configured to only allow the coupling of the second mode to the load. Optionally, the device may also comprise a microwave filter to protect the first mode from dissipating in the load. This microwave filter may be interleaved between the load and the coupler. From the point of view of the circuit, this filter aims at preventing the microwave photons at the first resonant frequency to escape the circuit. This can either be done by realising a band stop filter at the first resonant frequency or by realising a bandpass filter at the second resonant frequency as the photon of the second mode are the only ones that need to dissipate in the environment. For some circuits, in which the two modes have different symmetries, the filter may not be necessary, and the proper symmetry of the coupler may be sufficient to prevent the dissipation of the first mode.

Thus, the device enables the stabilisation of 2N coherent states in the first mode, that is, a quantum manifold of coherent states. For example, the microwave source applying the microwave radiation to the second mode through the microwave filter may be seen as a 2N photon drive of the first mode once converted by the resonant 2N-to-1 photon exchange, and the load that dissipates photons of the second mode only may be seen as a 2N photon dissipation of the first mode once converted by the resonant 2N-to-1 photon exchange. The 2N photon drive and 2N photon dissipation enables the stabilisation of 2N coherent states in the first mode.

The single photon drive on the second mode is formally described by the Hamiltonian $H_b = \hbar\epsilon_b b^\dagger + \hbar\epsilon_b^* b$ where $\varepsilon_b$ is the single photon drive strength on the second mode due to the microwave source. The single photon dissipation on the second mode is formally described by the Lindblad operator $L_b = \sqrt{\kappa_b}\, b$ where $\kappa_b$ is the single photon dissipation resulting from the coupling of the second mode to the load.

The 2N-photon drive is formally described by the Hamiltonian $H_{2N} = \hbar\varepsilon_{2N}a^{\dagger 2N} + \hbar\varepsilon_{2N}a^{2N}$ where $\varepsilon_{2N} = 2\varepsilon_b g_{2N}/\kappa_b$ is the effective 2N-photon drive, $g_{2N}$ the 2N-to-1 non-linear conversion rate between the first mode and the second mode. The 2N-photon loss is formally described the Lindblad operator $L_{2N} = \sqrt{\kappa_{2N}}\, a^{2N}$ where $\kappa_{2N} = 4g_{2N}^2/\kappa_b$ is the 2N-photon dissipation rate. The amplitude $\alpha$ of the stabilized coherent states is finally given by $\alpha = \left(\frac{2\epsilon_{2N}}{\kappa_{2N}}\right)^{1/2N}$.

A method of realizing resonant cat-qubit circuits is further provided. This method comprises providing the superconducting quantum circuit as described above and applying a predetermined current of a constant intensity to the circuit or the device comprising the circuit such that the resonant frequency of the second mode is substantially 2N times the resonant frequency of the first mode, N being a positive integer, which effectively engineers a resonant 2N-to-1 photon exchange between the two modes respectively.

This method further comprises using the device comprising the circuit to stabilize a quantum manifold spanned by 2N coherent states, each having the same amplitude and a $\pi/N$ phase difference between each other. This is done by combining the resonant 2N-to-1 photon exchange dynamics provided by the resonant cat-qubit circuit with external dissipation and microwave radiation. Quantum information may eventually be encoded in this quantum manifold, such as a cat-qubit.

A quantum computing system is further provided. This quantum computing system may comprise at least one of the superconducting quantum circuit and/or the device comprising the circuit. The quantum computing system may be configured to use the superconducting quantum circuit and/or the device for performing high quality quantum computation protocols. In other words, the quantum system may use the superconducting quantum circuit and/or the device comprising the circuit for performing fault-tolerant quantum computation. This is made possible thanks to the fact that the intrinsic resonant 2N-to-1 photon exchange dynamics combined with external dissipation and microwave radiation stabilizes a quantum manifold spanned by 2N coherent states of the first mode, also called "cat-qubit states" in some applications. In this quantum manifold, the 2N coherent states have the same amplitude and there is a phase difference of $\pi/N$ among each coherent state. The quantum computing system may use these coherent states to define logical qubits, which are naturally protected to errors thanks to the quantum manifold being stable, notably against bit-flip errors. The quantum system may thus define operations (e.g., CNOT, Hadamard and/or Toffoli gates), which perform computations on the logical qubits. This opens up a full paradigm for implementing quantum algorithms in a fault tolerant manner.

The resonant cat-qubit circuit will now be discussed in more details.

The circuit may have a specific Hamiltonian when the predetermined current is applied to the circuit. As known in the field, a Hamiltonian is an operator corresponding to the total energy of the superconducting circuit, e.g., including both the kinetic energy and potential energy. The Hamiltonian may be used to compute the time evolution of the circuit. The Hamiltonian may be engineered to exhibit desired quantum dynamics, notably, the resonant 2N-to-1 photon exchange between respectively the first mode and the second mode. The Hamiltonian of the circuit is herein a function of a specific set of parameters of the superconducting quantum circuit and parameter of the predetermined current. The expression "parameter" designates any and all kind of physical parameter of the circuit and/or the predetermined current such as, e.g., capacitance, inductance, resistance, frequency, phase difference, energy levels, zero-point fluctuations of phase, Josephson energy or critical current, and other parameters such as voltage and/or current levels (e.g., a direct current (DC) bias) from the applied predetermined current. The set of parameters is specific in that it consists of parameters of the circuit and parameters of the predetermined current. In other words, the Hamiltonian does not depend on any other parameter than those specific parameters.

Yet in other words, the Hamiltonian depends on, and only on, the circuit and on the predetermined current. For the sake of explanation, the set of parameters may be denoted as a set P1 U P2, where U designates a union operator, the set of parameters P1 consists only of parameters of the circuit, and the set of parameters P2 consists only of parameters of the predetermined current (such as the induced DC bias).

The total energy of the superconducting quantum circuit thus does not depend on parameters of any device external to the superconducting quantum circuit or the predetermined current. Indeed, the Hamiltonian only depends on the set of parameters of the superconducting quantum circuit and/or the predetermined current, which may be predetermined according to quantum engineering specifications. The Hamiltonian thus does not depend on time and in particular does not depend on any time-varying excitation, e.g., from a parametric pump.

In various examples, the Hamiltonian may comprise linear terms. The linear terms describe the existence of modes hosted by elements of the circuit. In other words, each linear term describes the existence of a respective mode among the first and second modes hosted in the circuit.

The Hamiltonian may also comprise non-linear terms. The non-linear terms may describe the interaction between the first and second modes. The non-linear terms may also be called "mixing terms", by analogy with frequency mixing that occurs in classical non-linear microwave circuits. The non-linear terms may comprise a constant that may act as a prefactor. Said constant may describe the strength of the interaction between the first and second modes. The prefactor of the non-linear terms may be smaller or much smaller than the frequencies of the system. The non-linear terms may also be called resonant or non-resonant depending on how compatible they are with the preservation of energy.

The Hamiltonian may be expandable into a sum of terms. The expression "expandable into a sum of terms" should be interpreted as meaning that the operator admits a Taylor series approximation into a sum of terms, it being reminded that it represents the energy of the superconducting quantum circuit. The total number of terms may be finite or possibly infinite, yet the sum of terms always remains finite, per the Taylor series approximation. The sum may comprise dominant terms and a series of subsidiary terms. The expression "dominant term" should be interpreted as designating a term that has a significant impact on the dynamics of the system. For a term to be dominant, it must satisfy the two following conditions. First, the magnitude - whether in absolute terms or in an appropriate norm and with respect to the other terms in the Taylor series approximation - of the said term should have a significant contribution to the magnitude of non-linear part of the Hamiltonian. Second, the term should be resonant in the sense it is compatible with the preservation of energy. The series of subsidiary terms are the terms for which the magnitude of its sum is below the predetermined magnitude. This is all known per se from Taylor series approximations, and thus the subsidiary terms are hereinafter omitted. The Hamiltonian is expandable into a sum between at least a dominant term of the form $\hbar g_{2N} a^{2N} b^{\dagger} + \hbar g_{2N}^{*} a^{\dagger 2N} b$ and a series of subsidiary terms hereinafter omitted here.

In the dominant term $\hbar g_{2N} a^{2N} b^{\dagger} + \hbar g_{2N}^{*} a^{\dagger 2N} b$ , *a* is the annihilation operator of the first mode, *b* is the annihilation operator of the second mode. Conversely, $a^{\dagger}$ is the creation operator of the first mode, and $b^{\dagger}$ is the creation operator of the second mode. The dominant term $\hbar g_{2N} a^{2N} b^{\dagger} + \hbar g_{2N}^{*} a^{\dagger 2N} b$ is a polynomial in $a$, $a^{\dagger}$, $b$, $b^{\dagger}$, that describes the resonant 2N-to-1 photon exchange. Thus, the dominant term including the term $\hbar g_{2N} a^{2N} b^{\dagger}$ describes the annihilation of 2N photons of the first mode and the creation of one photon of the second mode. As the Hamiltonian is a Hermitian operator, the dominant term also includes a reciprocal term - also known as Hermitian conjugate, abbreviated as h.c. - $\hbar g_{2N}^{*} a^{\dagger 2N} b$ , where 2N photons of the first mode are created and one photon of the second mode is destroyed.

The scalar $g_{2N}$ is a function of the set of parameters consisting of parameters of the circuit and/or parameters of the predetermined current. As the scalar $g_{2N}$ is a prefactor of the dominant term, it denotes the strength of the interaction between the first and second modes, also called "intrinsic coupling strength", namely the term $a^{2N} b^{\dagger}$ (respectively its Hermitian conjugate). In other words, $g_{2N}$ describes the rate of the resonant 2N-to-1 photon exchange.

As the predetermined current is applied to induce the resonant 2N-to-1 photon exchange - that is, the predetermined current is tuned at the bias point -, the rate of the resonant 2N-to-1 exchange term, that is, the constant $g_{2N}$, is non-zero and the frequency matching condition ensures the term is resonant. In addition, the constant $g_{2N}$ is large in the sense of the Taylor series approximation compared to the other non-linear terms, which are thus subsidiary and will not be further described.

Thus, as the predetermined current is applied to induce the resonant 2N-to-1 photon exchange - that is, the frequency matching condition $2N\omega_a = \omega_b$ is satisfied -, the dominant term is a resonant term, i.e., it is compatible with energy preservation. For any N, the dominant term thus describes a non-linear interaction which is an odd power of the annihilation and creation operators.

The Hamiltonian may include other dominant terms such as a Kerr term $\hbar K_a a^{\dagger 2} a^2/2$, $\hbar K_b b^{\dagger 2} b^2/2$ or cross-Kerr terms $\hbar \chi_{ab} a^{\dagger} a b^{\dagger} b$. Said non-linear terms may have a significant magnitude and are resonant by nature regardless of any frequency matching condition - this only occurs for even powers of the annihilation and creation operators. These Kerr and cross-Kerr terms may be considered as harmful for the desired engineered dynamics. However, the Applicant has discovered that the corresponding constant of the other non-linear terms - that is, the constants $K_a$, $K_b$, $\chi_{ab}$, among others - can be made small thanks to the choice of circuit parameters as illustrated in examples below. In particular, the Applicant has discovered that they vanish near the optimal bias point. Thus, these terms are not further considered in the examples below and are only described for the sake of completeness.

The circuit may be configured to perform intrinsically a resonant 2-to-1 photon exchange between respectively the first mode and the second mode. In other words, N is equal to 1. In this case, the dominant term of the Hamiltonian may be a two-to-one interaction Hamiltonian $\hbar g_2 a^2 b^{\dagger} + \hbar g_2^{*} a^{\dagger 2} b$ . Alternatively, N may be higher than 1, e.g., N= 2. Coherent states of the first mode are eigenstates of the annihilation operator $a$ acting on the first mode, e.g., for a given coherent state $|\alpha\rangle$, it results that $a|\alpha\rangle = \alpha|\alpha\rangle$, where $\alpha$ is a complex amplitude. In the paradigm of cat-qubits, the intrinsic 2-to-1 photon exchange stabilizes a quantum manifold of coherent states of the first mode. In the cat-cubit paradigm, cat-qubit states may be defined from the coherent states; for example, the logical qubit state $|0\rangle$ may be defined as $|\alpha\rangle$ and logical qubit state $|1\rangle$ may be defined as $|-\alpha\rangle$. Both logical states belong to the quantum manifold of coherent states stabilized by the 2-to-1 photon exchange. Cat-qubit states are naturally protected from errors such as bit-flip errors due to the stability of the quantum manifold achieved by the intrinsic 2-to-1 photon exchange. Indeed, bit-flip errors may be suppressed autonomously and with exponential speed. This allows the implementation of quantum gates acting on the logical qubit states, such as CNOT, Toffoli and/or Hadamard gates, to perform fault tolerant computations.

In various examples, the superconducting circuit may have a symbolic representation, e.g., consisting of a set of interconnected dipoles. The expression "symbolic representation" should be interpreted as designating an arrangement of symbols and lines which specify a set of interconnected dipoles. The set of interconnected dipoles (also called components) forms a circuit structure (or topology) equivalent (in functioning) to the non-linear superconducting circuit.

In other words, and as classical in the field of superconducting circuits, the non-linear superconducting circuit is configured to achieve the functioning defined by its symbolic representation, in other words the functioning of the theoretical set of interconnected dipoles shown by the symbolic representation. Yet again in other words, while the circuit may be constructed using a patterned layer of superconducting material, it is to be understood that the circuit admits a symbolic representation by dipoles, for example, capacitors, inductors, and/or Josephson junctions. While the example dipoles describe discrete elements, the man skilled in the clearly understands that these elements correspond to the equivalent circuit of distributed elements in a specific frequency range, e.g., at low frequency, as known in the field.

The interconnections of the set of interconnected dipoles of the symbolic representation may be described via a network topology. In the network topology of this symbolic representation, each branch may represent a dipole of the circuit, a node may be a point of connection between two or more branches, and a loop may be a closed path of the circuit, that is, a path formed by starting at a given node, and returning to the starting node without passing through any node more than once. Each branch may comprise components, e.g., two or more, connected in parallel or in series. For example, a pair of components comprising an inductor and a capacitor - that is, an LC resonator - may be implemented by distributed elements in the patterned layer of the superconducting material, such as:

- two neighboring plates forming a capacitor in parallel with a superconducting wire forming an inductor,
- a portion of superconducting transmission line which ends with 2 different boundary conditions (shorted to ground at one end and open at the other) forming a so-called $\lambda/4$ resonator. The transmission line being for example of the coplanar waveguide type or the microstrip type,
- a portion of superconducting transmission line which ends with 2 identical boundary conditions (open-open or short-short) forming a so-called $\lambda/2$ resonator, the transmission line being for example of the coplanar waveguide type or the microstrip type, or
- a 3D cavity carved in a block of superconducting material that resonates at given frequency which depends on its dimensions.

As known in the field, such distributed elements may have higher frequency modes which are irrelevant and unimportant for the dynamics described here. Hence, these distributed elements may be represented with the symbolic representation. This symbolic representation may be refined by adding elements such as series inductors with each wire connection or a parallel capacitor between any two nodes of the circuit or adding nodes and branches to take into account other modes of the distributed elements. Thus, the symbolic representation allows for a better description of the distributed elements without changing the working principle of the circuit. Hence, as known in the art, the physical circuit - that is the circuit which is actually manufactured - and its symbolic representation are considered equivalent by the man skilled in the art. Indeed, the refining dipoles of the symbolic representation only adjust the resonance frequencies or the zero-point fluctuation of the phase compared to the basic model. When designing the circuit, the final geometry may be fully and accurately simulated with a finite element solver which will readily give the frequencies of the modes, the dissipation originating from the loads and the zero-point fluctuation of the phase across the Josephson junctions which are the only unknown to compute the resonant 2N-to-1 photon exchange rate in any configuration.

The symbolic representation of the circuit, e.g., the set of connected dipoles or components, may comprise at least one superconducting loop, that is, a series of cycle-forming connected components (described by dipoles in the symbolic representation). The at least one loop may include one or more Josephson junctions. Each Josephson junction may consist of a thin insulating layer separating two superconducting leads, that allow Cooper pairs to tunnel through the insulating layer. Each Josephson junction may have a potential energy of the type $U(\varphi) = -E_J cos(\varphi)$ where $E_J$ is the Josephson energy of the junction and $\varphi = \dfrac{2\pi\Phi}{\Phi_0}$ where $\Phi$ is the integral of the voltage across the junction and $\Phi_0$ is the flux quantum. In various examples, the Josephson energy may be tuned during fabrication by choosing the surface and thickness - hence the room temperature resistance - of the insulating barrier.

The Josephson junction may be called a non-linear inductor. Indeed, by comparing the potential energy of an inductive element $U(\varphi) = E_L\varphi^2/2$ where $E_L$ is the inductive energy, with the potential energy of the junction, at first order in $\varphi$ the junction behaves as an inductor. When the predetermined current is applied to the circuit, the internal current flows through the junction, either from a direct connection or from the mutual inductance with the superconducting loop, the junction is embedded in, and this induces a phase-drop $\varphi_{DC}$ across the junction. Thus, the application of the predetermined current modifies the potential energy of the Josephson junction as follows:

$$U(\varphi) = -E_J \cos(\varphi_{DC} + \varphi) = -E_J \cos(\varphi_{DC}) \cos(\varphi) + E_J \sin(\varphi_{DC}) \sin(\varphi).$$

The first term on the right side of the sum of the above equation is a cosine non-linearity describing a change of the effective Josephson energy of the junction $E_J \rightarrow E_J \cos(\varphi_{DC})$. Since the inductance of the Josephson junction is inversely proportional to the Josephson energy, the DC offset $\varphi_{DC}$ enables tuning the inductance of the junction and hence the frequencies of the modes that participate in this junction. In the examples, the DC offset may be tuned to reach the frequency matching condition $2N\omega_a = \omega_b$. The second term describes a non-linearity corresponding to a sine non-linearity. The Taylor series expansion of the sine none-linearity comprise terms of odd powers of $\varphi$ providing odd wave mixing, and thus comprise the terms describing resonant 2N-to-1 photon exchange. In particular, the point at which the phase drop takes the value $\varphi_{DC} = \pi/2$ is where the junction's inductance becomes infinite and thus the junction behaves as an open element. Consequently, the cosine non-linearity of the potential energy vanishes, that is, the potential energy is zero, and the sine non-linearity is at its maximum.

The other inductive element in the loop that are linear may keep the same inductance when a DC current flow through the loop or a DC phase-drop develops across the loop. In examples, a Josephson junction of energy $E_J$ embedded in the at least one loop of inductive energy $E_L$, may be described via the ratio $\beta = \dfrac{E_J}{E_L}$. When biased by the predetermined current, equivalently described by the effective magnetic flux $\varphi_{ext}$ that passes through the loop, an internal DC current arises in the superconducting loop and produces a phase drop $\varphi_{DC}$ across the junction that depends only on $\varphi_{ext}$ and $\beta$. In examples, the phase drop may be computed numerically as the solution of the following equation: $\varphi + \beta \sin(\varphi + \varphi_{ext}) = 0$, with $1 + \beta \cos(\varphi + \varphi_{ext}) > 0$.

The solution of the above equation may be called $f(\varphi_{ext}, \beta)$. For example, when a loop of inductance $E_L$ comprises 2 junctions, each one having an energy $E_J$, the phase drop across each junction is denoted by $\varphi_{DC} = f(\varphi_{ext}/2, \beta/2)$.

The Hamiltonian of the circuit may be determined in any manner. For example, the Hamiltonian may be determined by first determining the equivalent inductance of each junction when the predetermined supercurrent is applied to the circuit. This equivalent inductance (which depends on the DC phase-drop across the junction) is given by $L_J = \varphi_0 / E_J \cos(\varphi_{DC})$, where $\varphi_0$ is the reduced flux quantum $\Phi_0/2\pi$. The frequencies of the mode may be computed algebraically or numerically, by replacing the junction in the circuit by its equivalent inductance, it may also be performed for more complex circuit layouts by performing microwave simulation with finite elements. These frequencies directly give out the linear part of the Hamiltonian. The modes frequencies can be computed along with the mode geometry which describes between any two points of the circuit what oscillating phase difference exist when the mode is excited.

The magnitude of the oscillating phase difference imposed across the Josephson junctions will be of particular interest to compute the non-linearity of the system. In the quantum regime, the phase difference across the junction may be written as $\varphi = \varphi_{DC} + \varphi_a(a + a^\dagger) + \varphi_b(b + b^\dagger) + \cdots$, where $\varphi_{DC}$ is the DC phase offset computed earlier, $\varphi_a$ and $\varphi_b$ are the zero-point fluctuation of the phase across the junction which is directly to the geometry of the mode up to a normalization. The phase difference may include other terms in "...", e.g., associated with other modes. These terms are hereinafter omitted since they are not relevant in this context.

The non-linear terms of the Hamiltonian may be computed by performing a Taylor approximation on the potential energy of the junction, $-E_J \cos(\varphi)$, and by summing the contribution of each junction of the circuit. All that is required to fully describe the circuit is to find out the DC phase drop across the junction, the frequencies of the modes and the zero-point fluctuations of the phase across the junction associated with each mode of the system.

In various examples, as the circuit hosts the first and second modes at respective frequencies $\omega_a/2\pi$ and $\omega_b/2\pi$, the linear part of the Hamiltonian may be written as $H = \hbar\omega_a a^\dagger a + \hbar\omega_b b^\dagger b$, where $\hbar$ is the reduced Plank constant.

Given that at least one term of the interaction provided by the Josephson junction is of the form $H_J = E_J \sin(\varphi_{DC}) \sin(\varphi_a(a + a^\dagger) + \varphi_b(b + b^\dagger))$, where $\varphi_{DC}$ is the DC phase-drop across the junction induced by the predetermined current and $\varphi_a$ and $\varphi_b$ are the zero-point fluctuation of the phase across the junction associated with the first mode and second mode respectively. The Hamiltonian may thus be expanded in a Taylor series, e.g., in any desired with respect to the Taylor series expansion, to obtain the resonant 2N-to-1 photon exchange Hamiltonian $H_{NL} = \hbar g_{2N} a^{2N} b^\dagger + h.c$, where $\hbar g_{2N} = E_J \dfrac{\varphi_a^{2N} \varphi_b}{2N!}$ is the resonant 2N-to-1 photon exchange rate that is resonant provided $2N\omega_a = \omega_b$. Thus, the resonant 2N-to-1 photon exchange only depends on the parameters of the circuit and of the predetermined current, such as said parameters.

By contrast, and as mentioned previously, existing cat-qubit circuits rely on the use of a parametric pump to perform the 2-to-1 photon exchange. In these prior art realisations, the two-to-one photon interaction Hamiltonian is of the form $\dfrac{H_2}{\hbar} = g_2(t) a^2 b^\dagger + h.c$. In these cases, the coupling term $g_2(t)$ is modulated via the parametric pump, where the pump injects an external time-varying parameter having a frequency $\omega_p = 2\omega_a - \omega_b$. The parametric pump is used in the prior art to render the non-linear interaction resonant but has detrimental effects.

Examples and illustrations of the circuit and device will now be discussed with reference to the figures. In the following, the expression "resonant cat-qubit circuit", "circuit" and "superconducting circuit" are interchangeable and designate the circuit performing the 2N-to-1 photon exchange allowing to stabilize the cat-qubit when the second mode is properly driven and made dissipative.

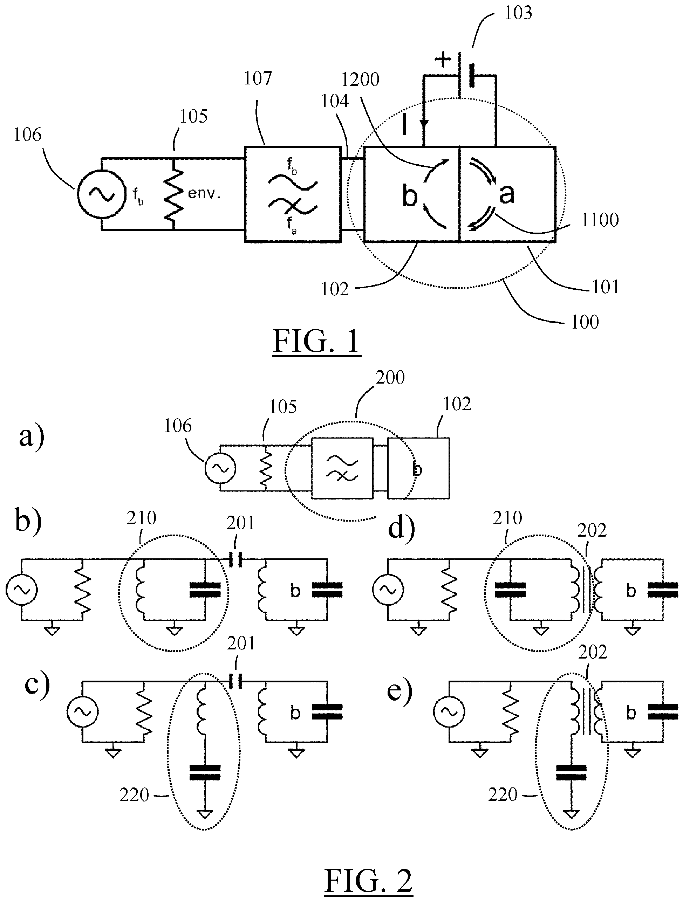

Figure 1 shows an example of the device comprising the resonant cat-qubit circuit.

For the sake of illustration, N will be equal to 1 hereinafter, but the same also applies to the case of other integer values of N. The device incorporates a non-linear superconducting circuit 100, which performs intrinsically the 2-to-1 photon exchange symbolized by a back-and-forth single arrow 1200 and the double arrows 1100 between a first mode *a* 101 and a second mode b 102. A current source 103 is connected via wires to the non-linear superconducting circuit 100. In other words, the current source 103 is directly connected to the circuit so that the predetermined current flows through at least a subset of elements of the non-linear superconducting circuit 100. The current source 103 is configured to apply the predetermined current to the circuit 100. The current source 103 both enables a 3-wave mixing interaction and tunes the frequency matching condition as $2f_a = f_b$. The components of the circuit hosting the second mode 102 are coupled via a coupler 104 to a load 105. This coupling renders the second mode dissipative. The device also incorporates a microwave source 106 at frequency $f_b$ used to drive the circuit 100. The device incorporates a microwave filter 107 configured as a bandpass filter with a frequency $f_b$. Alternatively, the filter 107 may be configured as a band stop filter at a frequency $f_a$, and may be placed in between the environment and the two modes to isolate the first mode and thus prevent the first mode from suffering additional losses coming from unwanted coupling to the load 105.

Figure 2 shows examples of the coupling of the second mode of the superconducting circuit to the load, and filters that may be integrated to the device to allow the coupling of only the second mode to the load.

Schematic a) of Figure 2 shows the coupling 200 to the device via the coupler 104 and the filter 107, so as to couple the second mode 102 of the circuit 100 of Figure 1 to the load, and to ensure driving the circuit 100 with a microwave source 106 at frequency $f_b$, while only allowing losses of the second mode; modeled as a resistor 105, at the second resonant frequency $f_b$ and not allowing losses of the first mode at the first resonance frequency $f_a$. Figure 2 admits at least two possibilities for the coupling 200: a bandpass filter (also shown in schematics b) and d) of Figure 2) at frequency $f_b$ or band stop filter (also shown in schematics c) and e) of Figure 2) at frequency $f_a$. Yet alternatively, when the circuit is manufactured in a 3D architecture, another possible solution is the use of a waveguide high-pass filter to couple to the second mode to the load, thanks to the high frequency selectivity.

Schematics b) to e) of Figure 2 show the different possibilities for the coupling 200. Schematic b) shows a bandpass filter 210 at frequency $f_b$ capacitively coupled (201) to the input port. The bandpass filter (which is an LC oscillator) 210 is configured to resonate at frequency $2\pi f_b = \sqrt{1/LC}$, its impedance $Z = \sqrt{L/C}$ tunes the width of the bandpass.

Schematic c) shows a band stop filter 220 at frequency $f_a$ capacitively coupled 201 to the input port. The band stop filter 220, which is an LC stub, is configured to resonate at frequency $2\pi f_a = \sqrt{1/LC}$, its impedance $Z = \sqrt{L/C}$ tunes the width of the band stop.

Schematic d) shows a bandpass filter 210 at frequency $f_b$ inductively coupled 202 to the input port. The bandpass filter 210, which is an LC oscillator, is configured to resonate at frequency $2\pi f_b = \sqrt{1/LC}$, its impedance $Z = \sqrt{L/C}$ tunes the width of the bandpass. This configuration is convenient because the microwave radiation (e.g., RF) input port of the device can also be used to input the current bias.

Schematic e) shows a band stop filter 220 at frequency $f_a$ inductively coupled (202) to the input port. The band stop filter, which is an LC stub; is configured to resonate at frequency $2\pi f_a = \sqrt{1/LC}$, its impedance $Z = \sqrt{L/C}$ tunes the width of the band stop.

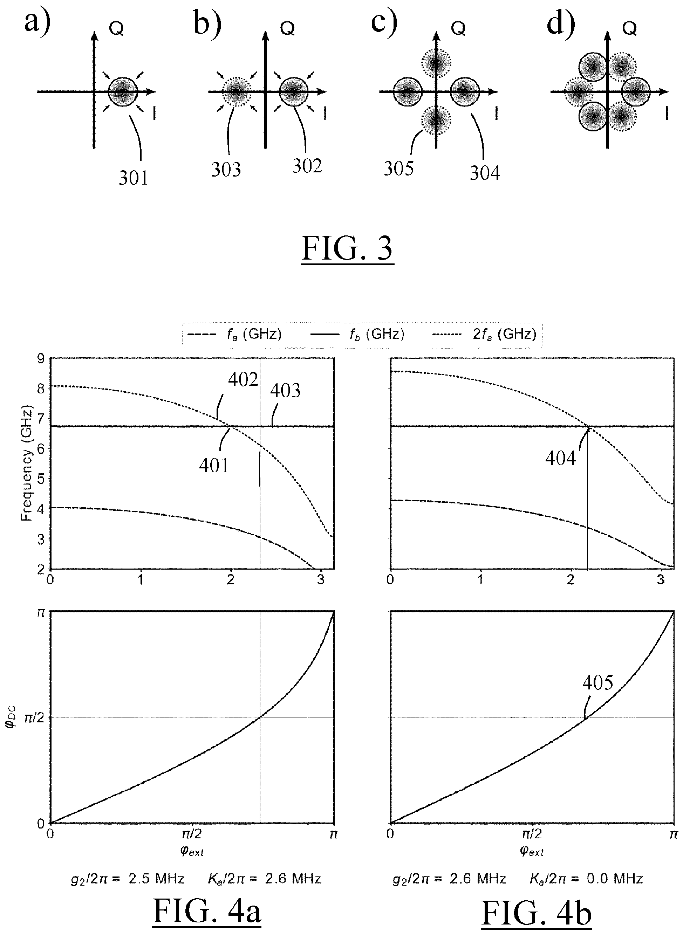

Figure 3 illustrates examples of stabilization a quantum manifold of coherent states of the first mode, achieved by the resonant 2N-to-1 photon exchange.

Schematic a) of Figure 3 illustrates a linear scheme comprising a single photon drive - a microwave tone at the mode frequency - characterized by an amplitude $\varepsilon_1$ and single photon dissipation with rate $\kappa_1$. After a timescale $1/\kappa_1$, the mode state converges to a single coherent state 301 of amplitude $\alpha = 2\varepsilon_1/\kappa_1$. This is the stable steady state of the dynamics. However, this steady state is unique and one cannot encode information into it. The state is represented as a blurry point in the quadrature space of the mode due to the uncertainty principle of quantum mechanics.

Schematic b) of Figure 3 illustrates a first mode undergoing a two-photon drive with strength $\varepsilon_2$ and two-photon dissipation with rate $\kappa_2$ that has 2 stable steady states (302, 303) of amplitude $\alpha = \sqrt{2\varepsilon_2/\kappa_2}$ and with opposite phase. Since there are two possible states, one can encode information: the state $|0\rangle$ 302 is circled with a solid line and the state $|1\rangle$ 303 with a dotted line. This encoding is robust against bit-flip errors that flip the system between state $|0\rangle$ and state $|1\rangle$ due to the stable nature of the dynamics that converges to the two states. The encoding does not correct the other error channel, that is, phase-flip errors. However, an additional error correcting scheme may be added to treat this separately. This stabilization is made possible by coupling to an extra mode and by engineering a 2-to-1 photon exchange between the first mode and the second mode.

Schematic c) of Figure 3 illustrates the case N=2, which uses a 4-photon drive and 4-photon dissipation to stabilize 4 states in the phase space. In this 4-dimensional manifold, one can encode a state $|0\rangle$ in one superposition of 2 coherent states 304 shown in solid lines, and a state $|1\rangle$ in another superposition of 2 coherent states 305 shown in dashed lines. There remains 2 degrees of freedom in the 4-dimensional manifold which can serve as an error manifold used to perform first order quantum error correction This stabilization is made possible by coupling to an extra mode and by engineering a 4-to-1 photon exchange between the first mode and the second mode.

Schematic d) of Figure 3 illustrates the increase of the dimension of the stabilized manifold. The increase in dimension allows for a higher order error correction, compared to lower values of N. With 6 photon drive and 6 photon dissipation (that is, N=3), one can stabilize a 6-dimensional manifold of coherent states that can perform second order quantum error correction. This stabilization is made possible by coupling to an extra mode and by engineering a 6-to-1 photon exchange between the first mode and the second mode.

Figure 4 illustrates examples of how to determine the intensity of the current to be applied to the circuit to achieve the resonant 2N-to-1 photon exchange.

Figure 4a, shows the tuning of the predetermined current to be applied to the superconducting circuit. For a given N, the bias point is the point at which the resonant frequencies of the first and second modes fulfils the matching condition $2N\omega_a = \omega_b$. In other words, the equality may have a margin of error of the order of magnitude of a constant $g_{2N}$, which describes the rate of the resonant 2N-to-1 photon exchange. The bias point may be reached by varying the current of the circuit, and it corresponds to the point 401 that is experimentally determined by the anti-crossing between a virtual $2N\omega_a$ frequency line 402 and the $\omega_b$ spectroscopic frequency line 403. The parameters of the elements of the circuit may be chosen in a range where the respective frequencies of the two modes are close to the frequency matching condition.

For some circuits, there exists an optimal choice of parameters of the elements of the circuit. Thus, the bias point is an optimal bias point. At this optimal bias point spurious even terms such as Kerr and cross-Kerr terms are also cancelled as mentioned previously.

Figure 4b shows that the optimal bias point 404 may coincide with the point 405 where the DC phase drop across the junction is $\pi/2$. To reach this optimal bias point, parameters of the circuit may be adjusted at manufacturing. Alternatively, a separate tuning knob can be added. This extra tuning nob, which may be realized for instance by incorporating in the second mode a SQUID - two junctions in parallel, biased with an external current in order to control its frequency independently -, may be used as an extra degree of freedom to reach both the frequency matching condition and the vanishing Kerr condition. The man skilled in the art will recognize that this is only a matter of implementation.

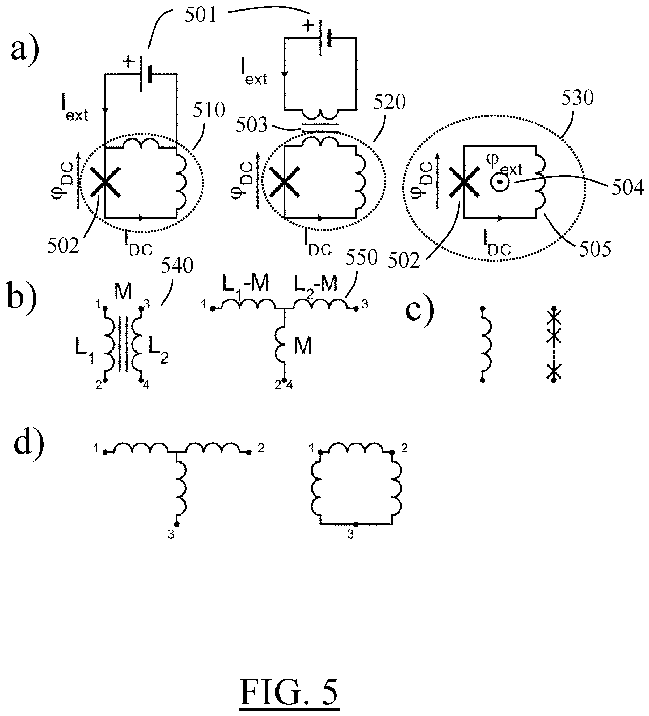

Figure 5 shows several examples of circuit symbolic representations alternatively used throughout this description.

Schematic a) of Figure 5 shows two example implementations of the current bias: a direct bias via galvanic connection and a mutual inductance bias symbolized by transformer 503 which generates a magnetic field to induce an internal current to the circuit. The first circuit (on the left hand of schematic a)) shows a current source 501 galvanically coupled to the superconducting loop. The examples show that at least one terminal of the current source is directly connected to the superconducting loop 510, which is isolated from the rest of the circuit for convenience. This is however a matter of implementation. The current source may be connected in any manner so as to apply the predetermined current, as shown below. When applying the predetermined current $I_{ext}$, a phase-drop $\varphi_{DC}$ flows across the junction 502. This is because a portion of the internal current $I_{DC}$ passes through the junction 502. The second circuit (at the right side of the first circuit) shows a current source inductively coupled to the superconducting loop via mutual inductance 503. This is diagrammatically shown as a transformer 503. The current source generates a magnetic field which in turns generates a current in the superconducting loop. This current is associated with a phase-drop across the junction.

The current source may thus be implemented in any manner so as to achieve a phase drop across the junction. Schematic a) of Figure 5 exemplifies this in the circuit 530 which equivalently summarizes the two circuits 510 and 520 of schematic a). Upon application of the predetermined current - by any one of the standard current source or by the transformer -, the flux $\varphi_{ext}$ 504 represents the effective magnetic field that biases the loop induced by the predetermined current applied to the circuit. The flux may also be called external flux $\varphi_{ext}$ when integrated on the surface of the loop in the following. The inductance 505 represents the total self-inductance of the superconducting loop in which is embedded the junction 502. This final notation is also used when the circuit is placed in a global magnetic field which may be produced by a magnetic coil outside the plane of the circuit the axis of which being perpendicular to the plane of the circuit. The external flux can be expressed as an angle $\varphi_{ext} = 2\pi\Phi_{ext}/\Phi_0$ where $\Phi_0$ is the flux quantum. For this application, it may be assumed that the system is periodic in $\varphi_{ext}$ with period $2\pi$ and symmetric with respect to $\varphi_{ext} = 0$. Hence, analysis may be restricted to the interval $\varphi_{ext} \in [0, \pi]$.

Schematic b) of Figure 5 shows an alternative description of the transformer as the current source. The transformer, here referenced 550, may be two circuit branches that are not galvanically connected - that is, not directly in contact - and which share a mutual inductance due to their proximity. Alternatively, the transformer 550 may be portion of the circuit where two loops galvanically share a common conductor. The transformer 550 can be effectively implemented in practice.

Schematic c) of Figure 5 shows replacing the inductances with arrays of junctions in series. Unless specified otherwise, this array can comprise as little as a single junction.

Schematic d) of Figure 5 shows a Y-Δ transform for inductors which can be used to change the topology of the circuit without changing its behavior producing an alternative circuit that simplifies the analysis, while following the same principles of the other embodiments.

The circuit may be configured to perform the resonant 2N-to-1 photon exchange when the predetermined current is applied to induce a phase difference across the one or more Josephson junctions. Examples below illustrate how the energy of the Josephson junction, and more generally of a non-linear inductive device, may be engineered to perform the resonant 2N-to-1 photon exchange. The presence of at least one loop including one or more Josephson junctions facilitates the intrinsic resonance of the circuit. Indeed, the energy of the Josephson junction may depend on the parameters of the components hosting the first and second modes, and the predetermined current inducing an internal current flowing through the at least one loop. Indeed, one or more Josephson junctions comprised in the loop provide mixing capabilities which enable the resonant 2N-to-1 photon exchange. That is, the energy of the one or more Josephson junctions describe the interaction of the first and second mode created by the resonant 2N-to-1 photon exchange when the predetermined current is applied through at least two nodes of the circuit.

Examples below are presented with the assumption that the circuit is operated at the optimal bias point per the above principles. This allows to improve the readability of the mathematical expressions provided below. However, it should be noted that the examples below also apply in the case of a non-optimal bias point.

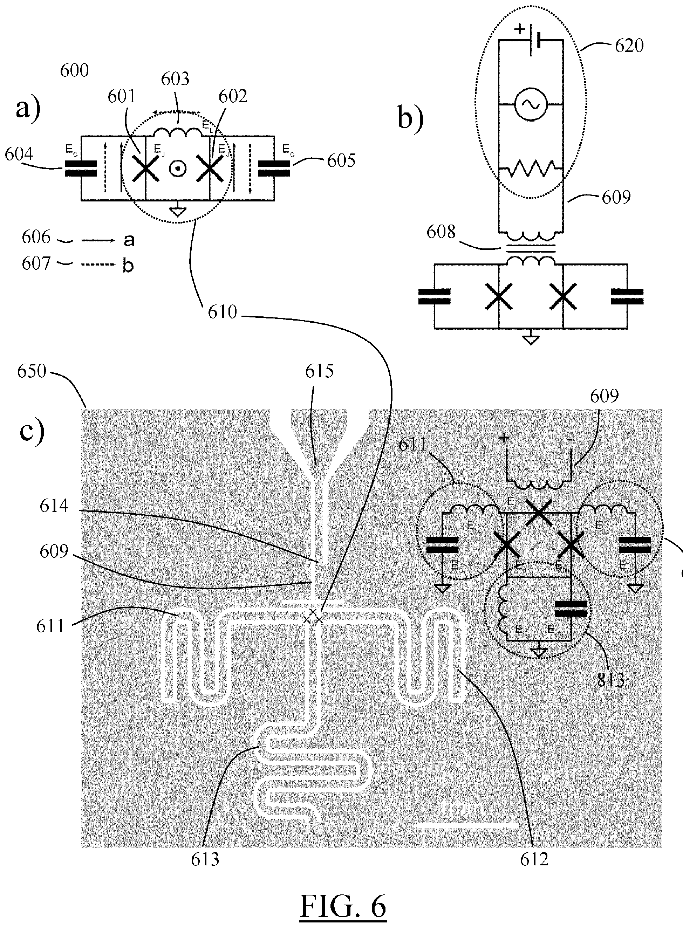

Figure 6 shows another embodiment in which the symbolic representation of the circuit comprises at least one loop that includes one or more Josephson junctions. The circuit 60600 according to this example is also configured to perform the resonant 2N-to-1 photon exchange when the predetermined current is applied to induce a phase difference across the one or more Josephson junctions. Circuit 60600 according to this example is particularly configured to discriminate symmetrically the first mode and the second mode. The high symmetry of the circuit achieves an improved quality of the resonant 2N-to-1 photon exchange.

With reference to schematic a) of Figure 6, an example of a circuit 60600 having at least one loop 610 will now be discussed. In the circuit 600, the at least one loop 610 may include a first Josephson junction 601, a central inductive element 603, and a second Josephson junction 602 arranged in series. The central inductive element 603 may be an inductance, a single Josephson junction or an array of Josephson junctions. The central inductive element 603 may thus be arranged between the first and second Josephson junctions as a loop in series. The arrangement in series may comprise a first inner node connecting a pole of the first Josephson junction 601 with a pole of the inductive element 603. The arrangement in series may also comprise a second inner node connecting a pole of the second Josephson junction 602 with another pole of the inductive element 603. The arrangement in series may also comprise a closed-loop node connecting another pole of the first Josephson junction 601 with another pole of the second Josephson junction 602.

Said at least one loop 610 may be connected to a common ground via the closed-loop node. The circuit may also comprise a first capacitor 604 and a second capacitor 605. The first capacitor 604 may be connected in parallel with the first Josephson junction 601 between the common ground and the first inner node of the loop. The second capacitor 605 may be connected in parallel with the second Josephson junction 603 between the common ground and the second inner node of the loop.

The superconducting quantum circuit 600 is thus configured to perform intrinsically the resonant 2N-to-1 photon exchange between respectively the first mode and the second mode when the predetermined current is applied. The Josephson junctions 601 and 602 are substantially identical and the capacitive elements 604 and 605 are also substantially identical. Hence, the symmetry of the circuit implies that the actual modes of the system are the symmetric superposition 606 of the two resonators (as shown by the full arrows) and the anti-symmetric superposition 607 of the two resonators (as shown by the dashed arrows). The first mode is the symmetric superposition 606 and the second mode is the antisymmetric superposition 607. One can notice that only the second mode has a contribution across the central inductive element 603 which is advantageously used to preferentially couple the environment to this second mode while isolating the first mode from the environment.

There is no optimal bias point in this circuit. Indeed, the junction cannot be both biased to $\varphi_{DC} = \pi/2$ and maximal budget of $\varphi_{ext} = \pi$ since there has to be a non-zero phase drop across the inductor. However, this is not problematic as an optimal bias point is not desired. Indeed, at such a point, the Josephson junction acts as an open circuit and thus only the parallel Josephson capacitance remains, which is in contradiction with the fact that, in this specific embodiment, the junction serves as a primary inductive element for the symmetric mode. An optimal bias point could be enabled by adding a loop. An exemplary implementation would be in a symmetrized version of the circuits of Figures 6a and 6b where both resonators are made identical and non-linear by replacing inductance 605 by the loop 610. As proposed in Figures 6a and 6b, the coupling between the two non-linear identical resonators can be capacitive or inductive.

Here the circuit 600 consists of two identical resonators that are strongly coupled via the central inductive element. This implies that the bare (before adding the coupling) detuning between the two resonators is zero and that the perturbative description performed for circuit 600 does not hold any more. Hence, the analysis presented here is different than that of the circuit 600. Assuming the system is perfectly symmetric - that is, both junctions and both capacitances are identical –, the system may be decomposed into a symmetric mode (i.e., the first mode $a$) and a anti-symmetric mode (i.e., the second mode $b$). In this eigenmode basis, one can compute the contribution of each junction to the Hamiltonian of the system:

$$H_J = -E_J \cos\left(\varphi_{DC} + \varphi_a(a + a^\dagger) + \varphi_b(b + b^\dagger)\right) -$$

$$E_J \cos\left(-\varphi_{DC} + \varphi_a(a + a^\dagger) - \varphi_b(b + b^\dagger)\right)$$

which can be factored as:

$$H_J = -2\,E_J \cos(\varphi_{DC}) \cos(\varphi_a(a + a^\dagger)) \cos(\varphi_b(b + b^\dagger))$$

$$+2E_J \sin(\varphi_{DC}) \cos(\varphi_a(a + a^\dagger)) \sin(\varphi_b(b + b^\dagger))$$

The two quadratic part of the first term gives the effective inductive energy of the junction at the working point of the system $2E_J \cos(\varphi_{DC})$. Together with the charging energy of the capacitors and the inductive energy of the central inductive element, it enables to define the frequencies $\omega_a = \sqrt{16 E_C E_J \cos(\varphi_{DC})}$ and $\omega_b = \sqrt{16 E_C (E_J \cos(\varphi_{DC}) + 2E_L)}$ and the zero point fluctuation of the phase $\varphi_a = \left(\frac{E_C}{E_J \cos(\varphi_{DC})}\right)^{1/4}$ and $\varphi_b = \left(\frac{E_C}{E_J \cos(\varphi_{DC}) + 2E_L}\right)^{1/4}$.

By expanding the second term at the desired order one can get the resonant 2N-to-1 photon exchange Hamiltonian $H_{NL} = \hbar g_{2N} a^{2N} b^\dagger + h.c.$ with $\hbar g_{2N} = 2E_J \sin(\varphi_{DC}) \frac{\varphi_a^{2N} \varphi_b}{2N!}$.

Because of the symmetry of the system and the frequency matching condition that must be satisfied at the bias point of the system, the expression may be further simplified. Indeed, since $2N\omega_a = \omega_b$, it can be shown that $4N^2 E_J \cos(\varphi_{DC})$ $= E_J \cos(\varphi_{DC}) + 2E_L$, and hence $\varphi_a = \sqrt{2N}\varphi_b$, leading to $\hbar g_{2N} = \sqrt{\frac{2}{N}} E_J \sin(\varphi_{DC}) \frac{\varphi_a^{2N}}{2N!}$.

Schematic b) of Figure 6 shows an example of the device used to stabilize a manifold of coherent states with the circuit 600. Looking at the figure from bottom to top, the non-linear superconducting circuit 600 lies at the bottom, and the inductive element shares a mutual inductance 608 with another inductor that terminates the environment 620 at the top. The environment 620 consists of a load, a microwave source, and a DC current source. In the same manner as explained above, the same input port of the device can conveniently be used to bring DC current for external flux and microwave radiation. In practice, a portion of transmission line is used to connect the circuit to the environment as mentioned previously. This portion of transmission line closest to the circuit 609 is typically a differential transmission line in order to preserve the symmetries of the circuit 600.

Schematic c) of Figure 6 shows an example of the planar superconducting pattern 650 and its circuit equivalent. The presented superconducting circuit is fabricated in a coplanar waveguide geometry (or CPW) where the background (greyed out part) represents the superconducting metal left on the dielectric substrate. Each cross in black represents a respective Josephson junction. By contrast with the device of schematic b), the inductive element is replaced with a single junction. In this embodiment, the central superconducting loop 610 is diluted by using three portions of CPW transmissions called stubs (611, 612, 613) in order to control the level of non-linearity of the system. On the left and on the right, open stubs 611 and 612 provide the required capacitance with some stray inductance in series. On the bottom, the ring is not directly connected to ground and a shorted stub 613 is interleaved to provide inductance to ground. The modes of the circuit and its working principle remains the same, but the lengths of transmission line added by the stubs enable to limit the level of non-linearity of the circuit. A transmission slotline 609 is used to inductively couple to the modes to the environment in order to couple preferentially to the second mode and preserve the symmetry of the circuit. A transition between CPW and slotline 614 is represented above in order to couple to the environment (and thus the current source) that have a common geometry 615 (e.g., CPW lines or coaxial cables).

The flux line design according to the invention will now be discussed. This design provides better properties for coherent state manifold stabilization compared to the embodiment of schematic c) of Figure 6. As a reminder, to be able to stabilize a coherent state manifold with the resonant cat circuit, it is required

-  to induce the bias current in the central loop to activate the non-linear conversion,

- to couple to the second mode or buffer mode to be able to drive it and to make it dissipative, and
- importantly not to couple the first-mode or cat-qubit mode.

Compared with the implementation proposed in application EP21306965.1, the invention aims at proposing a solution that fully satisfies these requirements with a single flux line. In particular, the circuit design 650 is improved to better couple in DC to the central loop and better couple in RF to the buffer mode.

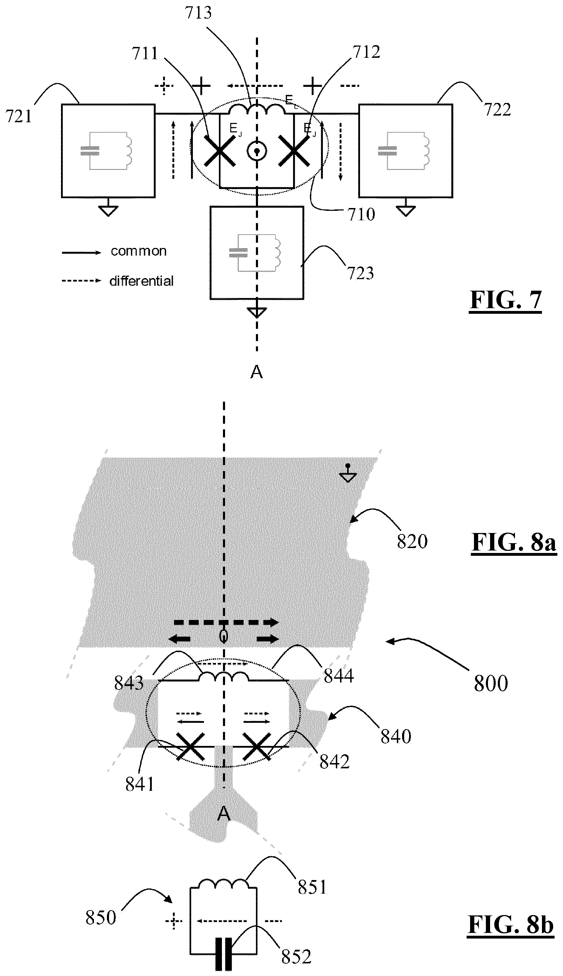

Figure 7 shows a generic circuit diagram of a resonant cat-qubit circuit to remind the important properties of the circuits proposed in Figure 6. In particular, the circuit is built around a central loop 710 comprising two substantially equal Josephson junctions 711, 712 and one central inductive element 713. The loop is arranged so that the two substantially equal Josephson junctions define a symmetry axis A. The details of the circuit portions 721, 722 on the left and on the right of the central loop and of the circuit portion 723 below it, except for they are symmetric according to the symmetry axis A, are not important for the invention that concentrates locally around the central loop. These circuit portions will be omitted in the following drawings. Due to the symmetry of the circuit, all the mode it supports are symmetrical or anti-symmetrical with respect to the symmetry axis. Symmetrical modes are also described as common modes and anti-symmetrical modes as differential modes. In the following, the focus is made on two modes of the circuit, a first one having a common geometry and storing the cat-qubit, a second one having a differential geometry used as a buffer mode in the context of cat-qubits. The mode geometry is emphasized by showing the voltage configuration around the central loop. In the following, the common mode is described with solid lines and the differential mode with dashed lines the current is represented with thick arrows and the difference of potential with thin arrows.

Figure 8 exemplifies an embodiment of a quantum device comprising a symmetrical resonant cat-qubit circuit without a flux line and as such not connected to an environment.

As shown on Figure 8a, device 800 comprises a ground plane 820, and a symmetric resonant cat-qubit circuit 840 for performing a 2N-to-1 photon exchange. The grey area represents superconducting material that lies on to a dielectric substrate and that is patterned to form the circuit hence delimited by exposed substrate portions, white area. Most of the superconducting material is within the ground plane 820 that surrounds the circuit. To explain the coupling strategy, it is useful to represent the mode current circulating in the ground plane, next to central loop which is circled and referenced 844. Importantly, it should be noted that the common mode current has a zero at the circuit symmetry axis A and the differential mode has a non-zero current at the same location.

Figure 8b represents a general equivalent circuit 850 of the differential mode in the configuration described in figure 8a that will be useful to characterize the coupling. This equivalent circuit comprises an inductive element 851 and a capacitive element 852 that are arranged horizontally such that the direction of the polarity of the circuit +/- matches the direction of the polarity of the differential mode of Figure 8a.

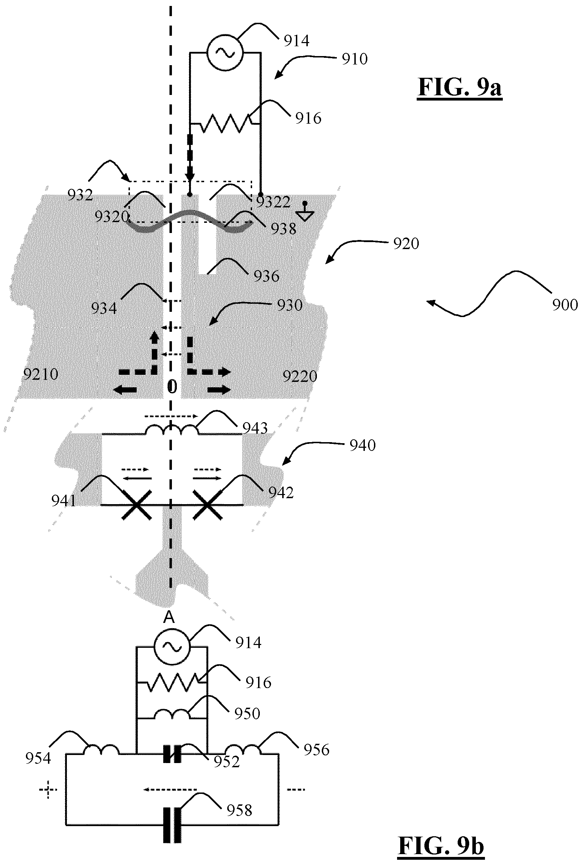

Figure 9 shows a first embodiment of a quantum device comprising a symmetrical resonant cat-qubit circuit and a flux line according to the invention.

As shown on Figure 9a, device 900 comprises an environment 910, a ground plane 920, a flux line 930 and a resonant cat-qubit circuit 940 for performing a 2N-to-1 photon exchange.

The environment 910 comprises a current source (not represented on Figure 9), a microwave source 914 and a load 916. In this embodiment, the current source is not represented because the focus is voluntarily made on the RF properties of the first mode (common mode or cat-qubit mode) and the second mode (differential mode or buffer mode) induced.

As shown by a triangle connected to a dot, the ground plane 920 is connected to a common ground. The flux line 930 is formed on the common ground 920 by exposing portions of the dielectric substrate on which the common ground 920 lies.

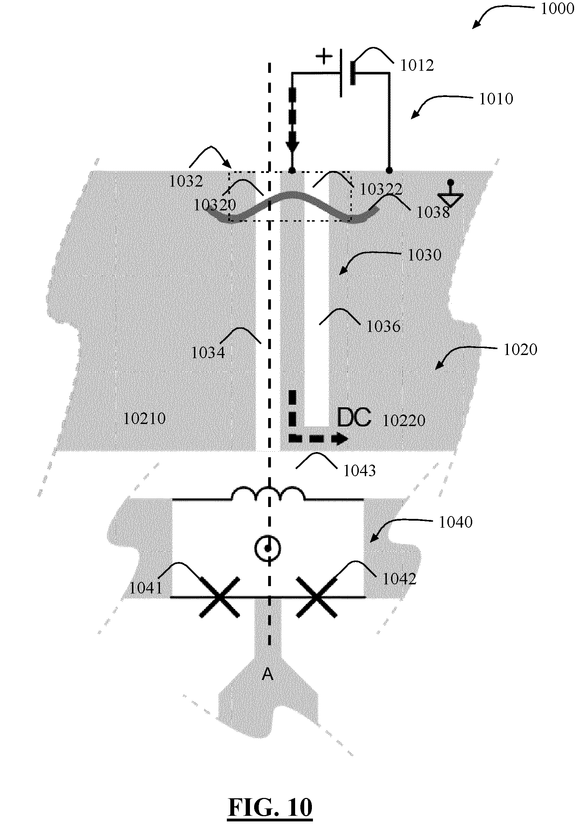

The flux line 930 comprises a coplanar waveguide (CPW) portion 932, a first slot 934, and a second slot 936. More precisely, the CPW portion 932 comprises a slot 9320 and a slot 9322 that delimit a central line that is further connected to the current source, the microwave source 914 and the load 916. The CPW portion 932 comprises several wire bonds for ensuring that the ground plane has the same potential on both sides of the CPW portion 932. For simplicity's sake, on Figure 9a and on Figures 10 to 12, the only represented wire bond is a wire bond 938, which is the wire bond closest to the resonant cat-qubit circuit 940 and delimitates the CPW portion 932 of the flux line 930 from the first slot 934 and the second slot 936.

In the example shown here, the resonant cat-qubit circuit 940 is similar to the circuit shown on schematic a) of Figure 6 in that it comprises two Josephson junctions 941 and 942 and a central inductive element 943 which is an inductance. In other embodiments, the central inductive element 943 may be a Josephson junction or an array of Josephson junctions.

As mentioned above, the main focus of this figure is to explicit the common mode and differential mode induced by this embodiment. In order to better explain these modes, the following convention has been used:

- full arrows relate to the common mode,

- dashed arrows relate to the differential mode,
- thick arrows relate to a current circulation, and
- thin arrows relate to a difference of potential.

Hence, the arrows, whether full or dashed and thick or thin show on Figure 9a the path of the current of the common mode and those of the differential mode. For instance, Figure 9a shows that the differential mode current comes from the environment down to the CPW portion 932 and that return current flows along the first slot 934.

As apparent on Figure 9a, the second slot 936 is much shorter than the first slot 934, while the first slot 934 is connected to the gap between the resonant cat-qubit circuit 940 and the rest of the ground plane 920. In other words, the first slot 934 splits the ground plane 920 into two unconnected portions 9210 and 9220.

In this embodiment, second slot 936 could be omitted. Both slots extend substantially parallel to an axis A. Axis A constitutes an axis of symmetry for the resonant cat-qubit circuit 940 and for the first slot 934. This use of the symmetry of the resonant cat-qubit circuit 940 is significant because the common mode has currents which run in opposite directions in ground plane portions 9210 and 9220, which results on the common mode current being null at the level of axis A whereas that of the differential mode is not null and induces a coupling with said differential mode. This results in the fact that the microwave radiation emitted by the environment 910 will couple almost exclusively with the differential mode and not with the common mode, which is essential for the stabilization of the cat-qubit. The expression "couples almost exclusively" or "couples substantially exclusively" should be construed as meaning that the coupling of the differential mode (respectively the common mode) is much greater than the coupling of the common mode (respectively differential mode). In a preferred manner, this ratio is more than 100. It is important to note that the fact that the slots 934 extends up to the central loop of the circuit and fully cuts the ground plane in two halves enables strong coupling to the differential mode. This is in stark contrast to the implementation of Figure 6 schematic c) where the slot does not fully cut the ground plane. The fact that the cut of this prior art does not fully extend creates a leftover galvanic path between the two halves of the ground plane which is interesting to couple to the DC current but at least partially shunts the RF coupling of the differential mode. As explained in Figure 2, the coupling ratio can be further improved by interleaving a microwave filter that would let both the DC and the microwave radiation at the differential mode frequency go through.

Figure 9b represents the equivalent circuit of the differential mode of the resonant cat-qubit circuit 940 when the device is operated to ensure the 2N-to-1 photon exchange, and the microwave source (respectively the load) and the differential mode are substantially exclusively coupled to this differential mode. In this case, the presence of the flux line affects the equivalent circuit of Figure 8b. In particular the cut induced by the slot 934 is represented by the capacitor 952, the remaining inductive path from the left ground plane 9210 to the right ground plane 9220 that goes through the wire bond 938 is represented by the inductor 950, the inductance 851 of Figure 8b is now cut in two halves 954 and 956 and the main capacitor 958 is mostly left unchanged. This equivalent circuit illustrates the fact that the coupling to the environment can be tuned by choosing the position of the wire bond 938. Indeed, by putting the wire bond further away from the resonant cat-qubit circuit, the impedance of the reactive path (which comprises inductor 950 and capacitor 952) is increased and hence the current of the differential mode favors going through the resistor i.e., the coupling to the environment is increased.

The Applicant's tests have revealed that this embodiment is very interesting in terms of microwave source and load coupling substantially to the differential mode and not to the common mode, but at the cost of a less satisfactory coupling of the current from the current source (hereinafter DC coupling) to provide the predetermined current.

Intuitively, the Applicant considered that, while centering the first slot 934 on the axis A allows to achieve substantially exclusive coupling of the microwave source 914 and the load 916 with the differential mode, the fact that the second slot 936 has to be very short (if not inexistent) to respect the symmetry of the device is the cause of the less satisfactory DC coupling.

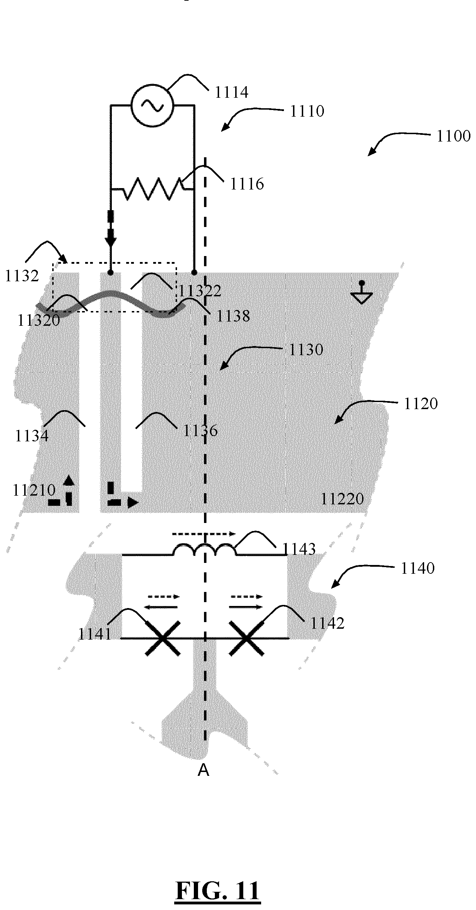

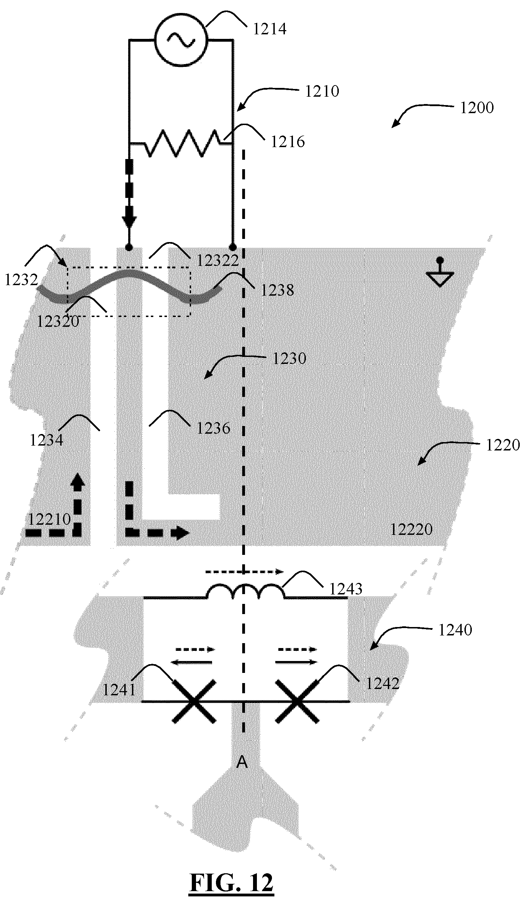

Hence, the Applicant prepared the second embodiment shown on Figure 10 in which similar elements to Figure 9a share identical reference numbers except for the first two digites, i.e., wire bond 938 of Figure 9a has the reference 1038 on Figure 10. The same will apply to figures 11 and 12.

For the sake of simplicity, only the differences with respect to Figure 9a will be described. The same will be true for figures 11 and 12 In this Figure, only current source 1012 has been shown, as the focus of this figure is to show the DC coupling.

In this embodiment, the only difference is that the second slot 1036 is almost as long as the first slot 1034, except that second slot 1036 does not extend all the way to the exposed dielectric substrate portion which corresponds to the delimitation of the portion of the resonant cat-qubit circuit 1040 which comprises the central inductive element 1043. For example, the distance between the extremity of the second slot 1036 and the above mentioned exposed dielectric substrate portion can be as low as $1\mu m$ and as high as some tens of $\mu m$. In this embodiment, and as shown by the thick dashed line, the DC current flows from the CPW portion 1032 along the first slot 1034 and the second slot 1036 and expands in the ground plane portion 10220, substantially orthogonally to the axis A and in a direction hereinafter referred to as "turning direction" which goes away from the first slot 1034.

The Applicant's analysis of the performance of this embodiment has shown that the DC coupling is greatly improved, but at the cost of a less performing differential mode coupling and an increase in the common mode coupling, which is unwanted. The Applicant has discovered that this is the result of the second slot 1036 becoming relevant with respect to the resonant cat-qubit circuit 1040 and thus breaking the symmetry of the device. Incidentally, it should be noted that second slot 1036 could be realized in mirror with respect to axis A of Figure 10.

In order to overcome the newly introduced defects, the Applicant had the idea to offset the flux line orthogonally to the axis A to re-establish the decoupling of the common mode.

This effort resulted in the embodiment exemplified of Figure 11. According to this embodiment, the first slot 1134 and the second slot 1136 are offset in a direction opposite the turning direction. This offset can be as little as $1\mu$m and as large as the width of the device, that is the first slot 1134 and the second slot 1136 will be at an extremity of the device.

The Applicant's analysis of the performance of this embodiment has shown that the common mode coupling demonstrate a sweet spot where the coupling to the environment vanishes while preserving the coupling of the differential mode, but that the differential mode coupling can be improved.

In order to overcome the newly introduced defects, the Applicant had the idea to add a return portion to the second slot 1236 substantially along the turning direction.

This effort resulted in the embodiment exemplified of Figure 12. According to this embodiment, the first slot 1234 and the second slot 1236 are still offset axially, but second slot 1236 is complemented with a return portion 12360. The return portion can be as little as $1\mu$m and as large as the width of the device, that is extend to the end of the device.

The Applicant's analysis of the performance of this embodiment has shown that it is the best performing embodiment, with the DC coupling and differential mode coupling being high while the common mode coupling is very small.

The Applicant has also discovered that the return portion can be used with some improvement with the second and third embodiment.

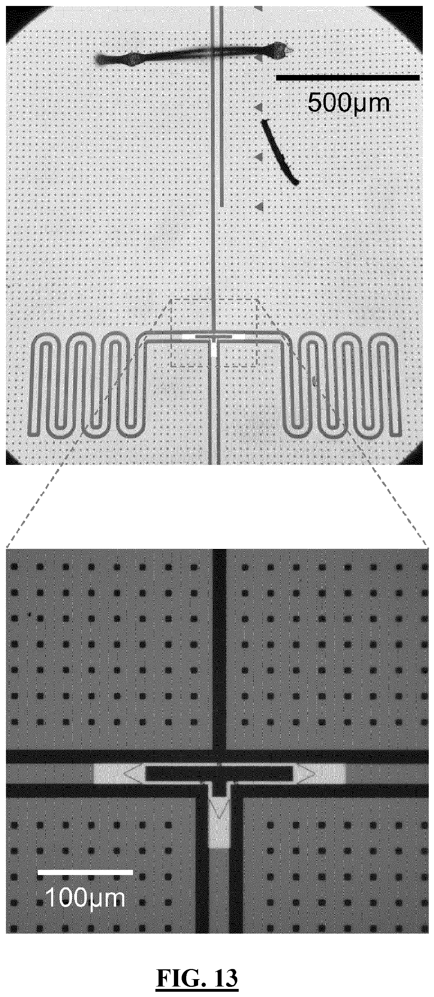

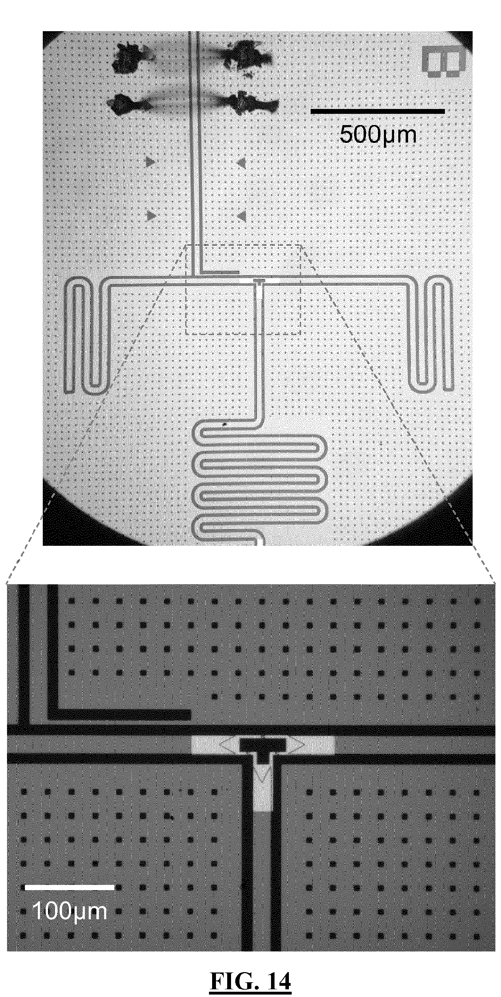

Figures 13 and Figure 14 show pictures of manufactured devices corresponding to respectively the embodiment of Figure 9 and the embodiment of Figure 12. In each figure, a zoomed portion enables to better see how the first slot splits the ground plane and how the first slot and second slot are situated with respect to the central mixing component.

The tests performed by the Applicant have shown that the circuit of Figure 13 allows to reach the target coupling for the differential $\kappa_b/2\pi$ of up to 100 MHz. However, the DC coupling to the central loop can be improved, as it is around 0.1 flux quantum ($\Phi_0$) per mA of current depending on the precise wire bond configuration. This is achieved with the circuit of Figure 14, which also achieves the target coupling for the differential mode, that is $\kappa_b/2\pi$ of up to 50 MHz, and a DC coupling to the central loop of the order of 1 flux quantum per mA of current which is a typical targeted parameter in the field.

The measurement method according to the invention will now be discussed.

Cat-qubits belong to the family of the bosonic qubits that are encoded in a harmonic oscillator that we will also call the cat-qubit mode. Contrary to two-level systems, harmonic oscillators have infinitely many levels than can be used to encode information.

Tomography is an operation that enables to get the full knowledge of the state of a quantum system. This operation requires the measurement of different observables. For a two-level system, the measurement of the observable X, Y and Z are sufficient to fully characterize the state of the system. For a harmonic oscillator that has infinitely many energy levels, one must make assumptions on the system to be able to perform the tomography with a finite number of measurements. Generally, the system is assumed to be lying within the low energy Fock states subspace. Several forms of measurements can be performed experimentally with harmonic oscillators in superconducting circuits such as the Husimi-Q function or the Wigner function and its corresponding characteristic function. These functions are defined over the phase space of the oscillator which quadratures are referred to as I and Q. One can directly measure these functions by sampling a finite portion of the phase-space. From this finite sampling and the assumption of the system being with low energy subspace, one can use maximum-likelihood algorithms to reconstruct the state of the system which finalizes the tomography.

More specific assumptions concerning the subspace in which the system lies can be made. For instance, in the cat-qubit paradigm, the coherent state manifold stabilization limits the possible states to be within the span of 2N coherent states. Hence, with this assumption, less measurements are required to perform the tomography of the system. For example, in the case of a two component cat qubit that is defined within the span of the two coherent states $\{|\alpha\rangle, |-\alpha\rangle\}$, one can either perform the full Wigner function measurement of the state or measure the effective X, Y or Z just as with a two-level physical system. The former is mostly used to tune and characterize the superconducting circuit operation and the latter during computation. In that specific case, the measurement of X is also the parity of the photon number in the state and Z is a measure of whether the population is on one or the other coherent state. Another example consists in defining a qubit in the even manifold of the span of four coherent states $\{|\alpha\rangle, |i\alpha\rangle, |-\alpha\rangle, |-i\alpha\rangle\}$ in the so-called four-component cat paradigm. It should be clear that measuring the full Wigner function of a system is more complete than measuring some observables while making assumptions on the possible states. As a consequence, it is generally possible to reconstruct the average values of these observables using the full Wigner function.

In the context of cat-qubits, the Wigner function or its characteristic function will usually be easier to use. Indeed, while the Husimi-Q function also contains all the information in principle it is sensitive to noise in the cat-qubit context. The Wigner function at a point $\beta$ of the phase-space can be determined by measuring the parity of the field after displacing it by an amount $-\beta$ (as shown in the article by Sun, L., Petrenko, A., Leghtas, Z. et al. "Tracking photon jumps with repeated quantum non-demolition parity measurements", Nature 511, 444-448 (2014), https://doi.org/10.1038/nature13436). The characteristic function at a point $\beta$ of the phase-space can be determined by measuring the average value of the displacement operator $D(-\beta)$ (as shown in the article by Campagne-Ibarcq, P., Eickbusch, A., Touzard, S. et al. "Quantum error correction of a qubit encoded in grid states of an oscillator", Nature 584, 368-372 (2020), https://doi.org/10.1038/s41586-020-2603-3).

In the following, the Wigner function will be used because it contains more readily available information for cat-qubits. For example, in a two-component cat qubit, measuring X is the same as measuring the Wigner function in 0. However, it should be noted that the Husimi-Q function or the characteristic function of the Wigner function can also be used.

To measure the Wigner function, one needs to first displace the state of the system and then to measure the parity. Displacing the state corresponds to sending a finite duration pulse with a frequency close to the mode frequency such that the mode frequency lies within the pulse frequency spectrum. This pulse is made with a microwave source that is connected to the mode via a transmission line coupled to the mode. This coupling maybe capacitive, inductive or galvanic. The amplitude and phase of this pulse defines the amplitude and phase of the displacement. Measuring the parity can be done indirectly by coupling the mode to a two-level system and by mapping the parity of the field in the mode to the state of the two-level system. This mapping can be achieved by realizing an Hamiltonian that couples the photon number operator of the mode $a^\dagger a$ to either the Z or the X operator of the two-level system $H_Z = \hbar \frac{\chi}{2} a^\dagger a\, Z$ or $H_X = \hbar \frac{\chi}{2} a^\dagger a\, X$.

The former can be achieved using the so-called dispersive interaction (Sun, L., Petrenko, A., Leghtas, Z. et al. "Tracking photon jumps with repeated quantum non-demolition parity measurements", Nature 511, 444-448 (2014), https://doi.org/10.1038/nature13436), the latter by using the so-called longitudinal interaction (see for example the article by S. Touzard, A. Kou, N. E. Frattini, et al. "Gated Conditional Displacement Readout of Superconducting Qubits" Phys. Rev. Lett. 122, 080502) that can be activated with a parametric pump at the two-level system frequency. The state of the two-level system will rotate around the $Z$-axis (respectively X-axis) at a speed that depends on the photon number in the mode. By tuning the duration of the interaction to $\frac{\pi}{\chi}$, one can ensure that for even photon numbers in the oscillator, the two-level system accumulates an integer number of rotations and that for odd photon number, it accumulates a half-integer number of rotation. In the case of the dispersive interaction, if the two-level system starts in state $|+\rangle$ it will end up in state $|+\rangle$ if there is an even number of photons in the mode and in state $|-\rangle$ if there is in an odd number of photons. By measuring X, one determines if the qubit is in state $|+\rangle$ or $|-\rangle$ and hence determines the photon number parity. In the case of the longitudinal interaction, if the two-level system starts in state $|0\rangle$ it will end up in state $|0\rangle$ if there is an even number of photons in the mode and in state $|1\rangle$ if there is in an odd number of photons. By measuring Z, one determines if the qubit is in state $|0\rangle$ or $|1\rangle$ and hence determines the photon number parity.

Unfortunately, the basic interaction required to perform the Wigner tomography i.e., the coupling to the photon number operator $a^\dagger a$ is incompatible with the coherent state stabilization described previously. This is also true for its characteristic function that relies eighter on the coupling to $a^\dagger a$ or $(a + a^\dagger)$. This is not accidental: it is actually a wanted effect of the stabilization mechanism, which purpose is to inhibit spurious couplings. As a result, the Wigner function cannot be measured while the cat-qubit stabilization is on.

Some measurements that are compatible with the stabilization do exist, for instance it is possible to determine in which stabilized coherent state the system is by coupling the mode to a heterodyne detector (or homodyne detector if there are only 2 coherent states).

For a two-component cat-qubit, this would correspond to the measurement of Z. However, even though in theory, one could measure as well X, Y of a two-component cat state while the stabilization is on, the measurement of X and Y would require the engineering of a non-local Hamiltonian which is only at a theoretical proposal stage. As explained earlier measuring X experimentally boils down to a parity measurement which relies on interactions that are protected against by the stabilization just as in the Wigner tomography case.

For a four-component cat-qubit, measuring in which stabilized coherent state the system is would not measure an observable of the qubit and project the system out of the code-space.

Hence, one can only perform a few measurements while the stabilization is on and this set of measurements do not cover the needs for calibration or quantum computation.

In prior art, this problem is solved for stabilized two-component cat-qubits that rely on parametric pumping by simply turning off the parametric pump which enables the 2-to-1 photon exchange that is the key ingredient of the stabilization. In the case of the resonant cat qubit circuits described above, the intrinsically resonant nature of the stabilizing mechanism makes it impossible to use this solution since no parametric pump is required. The energy preservation is built-in as the buffer mode is tuned to have twice the frequency of the cat-qubit mode. Consequently, 2-to-1 photon exchange dynamics is always on, this statement being also true in the more general case of 2N-to-1 photon conversion.

Compared to previously proposed implementations, the fact that the resonant cat-qubit device comprises a flux line well coupled both in DC and in RF to the buffer (or differential mode or second mode) enables new possibilities for readout. In particular, this flux line enables to rapidly (in a few tens of ns) modify the predetermined current. By suddenly modifying the value of the predetermined current, the resonant frequencies of both the first mode and the second mode are modified such that the system shifts from the resonant frequency matching condition that is one enabler of the 2N-to-1 photon conversion. If one denotes by $\omega_a'/2\pi$ and $\omega_b'/2\pi$ the new frequencies of the modes and $\Delta_a = \omega_a' - \omega_a$ and $\Delta_b = \omega_b' - \omega_b$ the detunings from their frequencies $\omega_a/2\pi$ and $\omega_b/2\pi$ at the resonant frequency matching condition, then the 2N-to-1 photon conversion is turned off provided $|2\Delta_a - \Delta_b| > g_{2N}$ where $g_{2N}$ is the strength of the non-linear conversion. This is typically achieved by modifying the magnetic flux inside the central loop of the device by a fraction of flux quantum (typical unit of magnetic flux as known in the field). Depending on the DC coupling of the flux line this can be achieved by modifying the output current of the current source by less than 1 mA. In the following, we call the new predetermined current value the tomography bias point as opposed to the stabilization bias point where the 2N-to-1 photon conversion is active. Modifying the current can be done by any suited means, such as applying a square shape pulse, a ramp, or any other signal modification shape to account for the signal distortion between the current source and the device.

There exists another way to detune the frequencies of the mode from the resonant frequency matching condition by using the fact that in some embodiments the buffer mode has some Kerr non-linearity. These embodiments are preferably the ones where the central inductive element is a single Josephson junction. In that case, by suddenly applying a strong parametric pump on the buffer mode via the flux line or via another RF coupled line, at a frequency different from any non-linear transition in the device, the buffer frequency gets AC-stark shifted such that the effective resonant frequency of the buffer mode (and to a lower extent of the cat-qubit mode) is detuned from the one satisfying the frequency matching condition. This solution does not require fast DC current modification but also proves to have some detrimental effects on the device such as lowering the coherence times of the modes and two-level systems used for tomography or generally heating the modes of the device.

Once the system is detuned from the resonant frequency matching condition, any quantum measurement can be performed on the cat-qubit mode since the coherent state stabilization is not active anymore and the cat-qubit mode dynamics are free. Extra attention has to be taken when performing the measurement because cat-qubit mode frequency at the tomography bias point is now different than the one at the stabilization bias point. However, the accumulated phase of the cat-qubit state due to the difference of frequency of the two points can be computed and compensated while operating the cat-qubit.

In a preferred embodiment, on top of suddenly modifying the predetermined current to turn off the 2N-to-1 photon conversion, the drive on the buffer mode is also turned-off as it does not serve any purpose anymore.

If the quantum measurement is non-demolition (QND), then the stabilisation can advantageously be resumed by putting back the output of the current source at the stabilisation DC bias point. If the drive on the buffer mode was turned off, it should resume as well. Once again, the accumulated phase due to the cat-qubit mode detuning between the two bias points, should be computed and compensated.

**Claims**

1. A quantum device comprising:

    - a non-linear superconducting quantum circuit having a first mode and a second mode each having a respective resonant frequency and a central mixing component (840, 940, 1040, 1140, 1240) which comprises

        at least one loop (710) that includes a first Josephson junction (841, 941, 1041, 1141, 1241), a central inductive element (843, 943, 1043, 1143, 1243), and a second Josephson junction (842, 942, 1042, 1142, 1242) arranged in a series topology substantially symmetrical with respect to an axis (A) which maps the first Josephson junction (841, 941, 1041, 1141, 1241) to the second Josephson junction (842, 942, 1042, 1142, 1242) comprising a first inner node connecting a pole of the first Josephson junction (841, 941, 1041, 1141, 1241) with a pole of the central inductive element (843, 943, 1043, 1143, 1243), a second inner node connecting a pole of the second Josephson junction (842, 942, 1042, 1142, 1242) with another pole of the inductive element (843, 943, 1043, 1143, 1243), and a loop-closing node connecting another pole of the first Josephson junction (801) with another pole of the second Josephson junction (842, 942, 1042, 1142, 1242), a first circuit portion (721) connected between the common ground and the first inner node of the loop (710), and a second circuit portion (722) between the common ground and the second inner node of the loop (710), such that said first circuit portion (721) and said second circuit portion (722) are mutually substantially symmetrical with respect to said axis (A), and a third circuit portion (723) connected between said loop-closing node and the common ground and substantially symmetrical with respect to said axis (A),

said non-linear superconducting quantum circuit being configured such that, when a predetermined current of a constant intensity is applied, the resonant frequency of the second mode is substantially 2N times the resonant frequency of the first mode, a phase difference is induced across the one or more Josephson junctions (841, 941, 1041, 1141, 1241; 842, 942, 1042, 1142, 1242), such that the non-linear superconducting quantum circuit has an Hamiltonian expandable into a sum between at least a dominant term of the form

$$\hbar g_{2N} a^{2N} b^{\dagger} + \hbar g_{2N}^{*} a^{\dagger 2N} b$$ and a series of subsidiary terms, where $g_{2N}$ is a scalar corresponding to the intrinsic coupling strength, $a$ is the annihilation operator of the first mode, $b$ is the annihilation operator of the second mode, and $\hbar$ is the reduced Planck constant, thereby performing intrinsically a resonant 2N-to-1 photon exchange between respectively the first mode and the second mode, N being a positive integer, said non-linear superconducting quantum circuit lying on a dielectric substrate and being delimited from a common ground plane (820, 920, 1020, 1120, 1220) by exposed portions of said dielectric substrate,

- a flux line (930, 1030, 1130, 1230) located opposite the portion of said at least one loop (710) comprising said central inductive element (843, 943, 1043, 1143, 1243), comprising a first slot (934, 1034, 1134, 1234), and a CPW portion (932, 1032, 1132, 1232),

said CPW portion (932, 1032, 1132, 1232) being arranged to be coupled to a current source (1012), a microwave source (914, 1114, 1214) configured to apply a microwave radiation, and a load (916, 1116, 1216), and being delimited by an end wire bond (938, 1038, 1138, 1238),

said first slot (934, 1034, 1134, 1234) being patterned within said ground plane exposing said dielectric substrate, extending substantially parallel to said axis (A), being connected at one end to a slot (9320, 10320, 11320, 12320) of said CPW portion (932, 1032, 1132, 1232) at the level of said end wire bond (938, 1038, 1138, 1238), and at the other end to the exposed dielectric substrate portion delimiting the portion of said at least one loop (710) comprising said central inductive element (843, 943, 1043, 1143, 1243),

said flux line (930, 1030, 1130, 1230) being configured such that it allows the coupling of said current source (1012) to induce said predetermined current in said at least one loop (710), allows coupling of said microwave radiation source (914, 1114, 1214) to induce a drive of the second mode at a frequency substantially equal to the resonant frequency of the second mode or 2N times the resonant frequency of the first mode, and allows coupling a load (916, 1116, 1216) substantially exclusively with said second mode.

2. Quantum device according to claim 1, wherein said flux line (930, 1030, 1130, 1230) further comprises a second slot (936, 1036, 1136, 1236) being patterned within said ground plane exposing said dielectric substrate, extending substantially parallel to said axis (A), being connected at one end to another slot (9322, 10322, 11322, 12322) of said CPW portion (932, 1032, 1132, 1232) at the level of said end wire bond (938, 1038, 1138, 1238), and ending at the other end within said ground plane (820, 920, 1020, 1120, 1220) at a distance from said portion of said at least one loop (710) comprising said central inductive element (843, 943, 1043, 1143, 1243) which is greater than 1µm.

3. Quantum device according to claim 2, wherein said second slot (936, 1036, 1136, 1236) comprises a return portion (12360) closest to said portion of said at least one loop (710) comprising said central inductive element (843, 943, 1043, 1143, 1243), said return portion (12360) extending substantially orthogonally to said axis (A) in a turning direction away from said first slot (934, 1034, 1134, 1234).

4. Quantum device according to claim 3, wherein said return portion (12360) length is greater than 1µm and up to the width of the non-linear superconducting circuit.

5. Quantum device according to one of the preceding claims, wherein said first slot (934, 1034, 1134, 1234) is substantially symmetrical with respect to said axis (A).

6. Quantum device according to one of claims 1 to 4, wherein said first slot (934, 1034, 1134, 1234) and second slot (936, 1036, 1136, 1236) are both offset in a direction orthogonal to said axis (A) and inverse to said turning direction.

7. Quantum device according to claim 6, wherein said offset is greater than 1µm and up to the width of the non-linear superconducting circuit.

8. Quantum device according to one of the preceding claims, wherein the length of said first slot (934, 1034, 1134, 1234) or alternatively the position of the wire bond (938, 1038, 1138, 1238) is chosen according to the intensity of the coupling intended between said second mode and said load (916, 1116, 1216).

9. Quantum device according to one of the preceding claims, wherein the coupling of said load with said second mode is more than 100 times greater than the coupling of said load with said first mode.

10. Quantum device according to one of the preceding claims, further comprising a current source (1012), a microwave source (914, 1114, 1214) and a load (916, 1116, 1216) coupled to said CPW portion (932, 1032, 1132, 1232) configured to stabilize a manifold of coherent states in said device.

11. A quantum measurement method for a device according to claim 10 comprising:

a) modifying the current output of said current source such that the predetermined current in said non-linear superconducting circuit induces a resonant frequency of the second mode substantially different from 2N times the resonant frequency of the first mode,
b) performing a quantum measurement on the first mode of said non-linear superconducting circuit.

12. Quantum measurement method according to claim 11, wherein the modifying of operation a) is performed by applying a square pulse to said current.

13. Quantum measurement method according to claim 11 or 12, wherein operation b) is a quantum nondemolition measurement, and further comprising the following operation:
c) restoring the current output of said current source to obtain the predetermined current after operation b) is performed.

14. Quantum computing system comprising at least one device according to any one of claims 1 to 10.

**Patentansprüche**

1. Quantenvorrichtung, umfassend:

- eine nichtlineare supraleitende Quantenschaltung mit einem ersten Modus und einem zweiten Modus, die jeweils eine Resonanzfrequenz aufweisen, und einer zentralen Mischkomponente (840, 940, 1040, 1140, 1240), umfassend

mindestens eine Schleife (710), die einen ersten Josephson-Übergang (841, 941, 1041, 1141, 1241), ein zentrales induktives Element (843, 943, 1043, 1143, 1243) und einen zweiten Josephson-Übergang (842, 942, 1042, 1142, 1242) enthält, die in einer Reihentopologie angeordnet sind, die im Wesentlichen symmetrisch zu einer Achse (A) ist, die den ersten Josephson-Übergang (841, 941, 1041, 1141, 1241) auf den zweiten Josephson-Übergang (842, 942, 1042, 1142, 1242) abbildet, umfassend einen ersten inneren Knoten, der einen Pol des ersten Josephson-Übergangs (841, 941, 1041, 1141, 1241) mit einem Pol des zentralen induktiven Elements (843, 943, 1043, 1143, 1243) verbindet, einen zweiten inneren Knoten, der einen Pol des zweiten Josephson-Übergangs (842, 942, 1042, 1142, 1242) mit einem weiteren Pol des induktiven Elements (843, 943, 1043, 1143, 1243) verbindet, und einen Schleifenschlussknoten, der einen anderen Pol des ersten Josephson-Übergangs (801) mit einem anderen Pol des zweiten Josephson-Übergangs (842, 942, 1042, 1142, 1242) verbindet, einen ersten Schaltungsabschnitt (721), der zwischen der gemeinsamen Masse und dem ersten inneren Knoten der Schleife (710) verbunden ist, und einen zweiten Schaltungsabschnitt (722) zwischen der gemeinsamen Masse und dem zweiten inneren Knoten der Schleife (710), so dass der erste Schaltungsabschnitt (721) und der zweite Schaltungsabschnitt (722) in Bezug auf die Achse (A) im Wesentlichen symmetrisch zueinander sind, und einen dritten Schaltungsabschnitt (723) zwischen dem Schleifenschlussknoten und der gemeinsamen Masse verbunden und in Bezug auf die Achse (A) im Wesentlichen symmetrisch ist, wobei die nichtlineare supraleitende Quantenschaltung so konfiguriert ist, dass, wenn ein vorbestimmter Strom einer konstanten Intensität angelegt wird, die Resonanzfrequenz des zweiten Modus im Wesentlichen das 2N-Fache der Resonanzfrequenz des ersten Modus beträgt, eine Phasendifferenz über den einen oder die mehreren Josephson-Übergänge (841, 941, 1041, 1141, 1241; 842, 942, 1042, 1142, 1242) induziert wird, so dass die nichtlineare supraleitende Quantenschaltung eine Hamilton-Funktion aufweist, die in eine Summe aus mindestens einem dominanten Term der Form $\hbar g_{2N} a^{2N} b^{\dagger} + \hbar g_{2N}^{*} a^{\dagger 2N} b$ und einer Reihe untergeordneter Terme erweiterbar ist, wobei $g_{2N}$ ein Skalar ist, der der intrinsischen Kopplungsstärke entspricht, *a* der Vernichtungsoperator des ersten Modus ist, b der Vernichtungsoperator des zweiten Modus ist und *h* die reduzierte Planck-Konstante ist, wodurch intrinsisch ein resonanter 2N-zu-1-Photonenaustausch zwischen dem ersten Modus bzw. dem zweiten Modus durchgeführt wird, wobei N eine positive Ganzzahl ist,

wobei die nichtlineare supraleitende Quantenschaltung auf einem dielektrischen Substrat liegt und von einer gemeinsamen Masseebene (820, 920, 1020, 1120, 1220) durch freiliegende Abschnitte des dielektrischen Substrats durch freiliegende Abschnitte des dielektrischen Substrats 51 abgegrenzt ist,

- eine Flusslinie (930, 1030, 1130, 1230), die sich gegenüber dem Abschnitt der mindestens einen Schleife (710) befindet, der das zentrale induktive Element (843, 943, 1043, 1143, 1243) umfasst, und die einen ersten Schlitz (934, 1034, 1134, 1234) und einen CPW-Abschnitt (932, 1032, 1132, 1232) umfasst,

wobei der CPW-Abschnitt (932, 1032, 1132, 1232) so angeordnet ist, dass er mit einer Stromquelle (1012), einer Mikrowellenquelle (914, 1114, 1214), die so konfiguriert ist, dass sie eine Mikrowellenstrahlung anwendet, und einer Last (916, 1116, 1216) gekoppelt ist und durch eine Enddrahtverbindung (938, 1038, 1138, 1238) begrenzt ist,
wobei der erste Schlitz (934, 1034, 1134, 1234) innerhalb der Masseebene gemustert ist, wodurch das dielektrische Substrat freigelegt wird, sich im Wesentlichen parallel zu der Achse (A) erstreckt und an einem Ende mit einem Schlitz (9320, 10320, 11320, 12320) des CPW-Abschnitts (932, 1032, 1132, 1232) auf Höhe der Enddrahtverbindung (938, 1038, 1138, 1238) und an dem anderen Ende mit dem freiliegenden dielektrischen Substratabschnitt verbunden ist, der den Abschnitt der mindestens einen Schleife (710) begrenzt, der das zentrale induktive Element (843, 943, 1043, 1143, 1243) umfasst,
wobei die Flusslinie (930, 1030, 1130, 1230) so konfiguriert ist, dass sie die Kopplung der Stromquelle (1012) ermöglicht, um den vorbestimmten Strom in der mindestens einen Schleife (710) zu induzieren, die Kopplung der Mikrowellenstrahlungsquelle (914, 1114, 1214) ermöglicht, um einen Antrieb des zweiten Modus mit einer Frequenz zu induzieren, die im Wesentlichen gleich der Resonanzfrequenz des zweiten Modus oder dem 2N-Fachen der Resonanzfrequenz des ersten Modus ist, und die Kopplung einer Last (916, 1116, 1216) im Wesentlichen ausschließlich mit dem zweiten Modus ermöglicht.

2. Quantenvorrichtung nach Anspruch 1, wobei die Flusslinie (930, 1030, 1130, 1230) ferner einen zweiten Schlitz (936, 1036, 1136, 1236) umfasst, der innerhalb der Masseebene gemustert ist, wodurch das dielektrische Substrat freigelegt wird, sich im Wesentlichen parallel zu der Achse (A) erstreckt und an einem Ende mit einem anderen Schlitz (9322, 10322, 11322, 12322) des CPW-Abschnitts (932, 1032, 1132, 1232) auf Höhe der Enddrahtverbindung (938, 1038, 1138, 1238) verbunden ist und an dem anderen Ende innerhalb der Masseebene (820, 920, 1020, 1120, 1220) in einem Abstand zu dem Abschnitt der mindestens einen Schleife (710) endet, die das zentrale induktive Element (843, 943, 1043, 1143, 1243) umfasst, das größer als 1 $\mu$m ist.

3. Quantenvorrichtung nach Anspruch 2, wobei der zweite Schlitz (936, 1036, 1136, 1236) einen Rücklaufabschnitt (12360) umfasst, der dem Abschnitt der mindestens einen Schleife (710) am nächsten liegt, der das zentrale induktive Element (843, 943, 1043, 1143, 1243) umfasst, wobei sich der Rücklaufabschnitt (12360) im Wesentlichen orthogonal zu der Achse (A) in einer Drehrichtung weg von dem ersten Schlitz (934, 1034, 1134, 1234) erstreckt.

4. Quantenvorrichtung nach Anspruch 3, wobei der Rücklaufabschnitt (12360) länger als 1 $\mu$m und bis zu der Breite der nichtlinearen supraleitenden Schaltung ist.

5. Quantenvorrichtung nach einem der vorhergehenden Ansprüche, wobei der erste Schlitz (934, 1034, 1134, 1234) in Bezug auf die Achse (A) im Wesentlichen symmetrisch ist.

6. Quantenvorrichtung nach einem der Ansprüche 1 bis 4, wobei der erste Schlitz (934, 1034, 1134, 1234) und der zweite Schlitz (936, 1036, 1136, 1236) beide in einer Richtung orthogonal zu der Achse (A) und entgegengesetzt zu der Drehrichtung versetzt sind.

7. Quantenvorrichtung nach Anspruch 6, wobei der Versatz größer als 1 $\mu$m und bis zu der Breite der nichtlinearen supraleitenden Schaltung ist.

8. Quantenvorrichtung nach einem der vorhergehenden Ansprüche, wobei die Länge des ersten Schlitzes (934, 1034, 1134, 1234) oder alternativ die Position der Drahtverbindung (938, 1038, 1138, 1238) entsprechend der Intensität der zwischen dem zweiten Modus und der Last (916, 1116, 1216) vorgesehenen Kopplung gewählt wird.

9. Quantenvorrichtung nach einem der vorhergehenden Ansprüche, wobei die Kopplung der Last mit dem zweiten Modus mehr als 100-mal größer ist als die Kopplung der Last mit dem ersten Modus.

10. Quantenvorrichtung nach einem der vorhergehenden Ansprüche, ferner umfassend eine Stromquelle (1012), eine Mikrowellenquelle (914, 1114, 1214) und eine Last (916, 1116, 1216), die mit dem CPW-Abschnitt (932, 1032, 1132, 1232) gekoppelt, so konfiguriert ist, dass sie eine Vielzahl kohärenter Zustände in der Vorrichtung stabilisiert.

11. Quantenmessverfahren für eine Vorrichtung nach Anspruch 10, umfassend:

a) Modifizieren der Stromausgabe der Stromquelle, so dass der vorbestimmte Strom in der nichtlinearen supraleitenden Schaltung eine Resonanzfrequenz des zweiten Modus induziert, die sich wesentlich von dem 2N-Fachen der Resonanzfrequenz des ersten Modus unterscheidet,
b) Durchführen einer Quantenmessung an dem ersten Modus der nichtlinearen supraleitenden Schaltung.

12. Quantenmessverfahren nach Anspruch 11, wobei das Modifizieren der Operation a) durch Anlegen eines Reckteckimpulses an den Strom durchgeführt wird.

13. Quantenmessverfahren nach Anspruch 11 oder 12, wobei die Operation b) eine zerstörungsfreie Quantenmessung ist und ferner die folgende Operation umfasst:
c) Wiederherstellen der Stromausgabe der Stromquelle, um den vorbestimmten Strom zu erhalten, nachdem die Operation b) durchgeführt wurde.

14. Quantencomputersystem, das mindestens eine Vorrichtung nach einem der Ansprüche 1 bis 10 umfasst.

**Revendications**

1. Dispositif quantique comprenant :

- un circuit quantique supraconducteur non linéaire ayant un premier mode et un deuxième mode ayant chacun une fréquence de résonance respective et un composant de mélange central (840, 940, 1040, 1140, 1240) qui comprend

au moins une boucle (710) qui inclut une première jonction Josephson (841, 941, 1041, 1141, 1241), un élément inductif central (843, 943, 1043, 1143, 1243), et une deuxième jonction Josephson (842, 942, 1042, 1142, 1242) agencées dans une topologie en série sensiblement symétrique par rapport à un axe (A) qui met en correspondance la première jonction Josephson (841, 941, 1041, 1141, 1241) et la deuxième jonction Josephson (842, 942, 1042, 1142, 1242) comprenant un premier nœud interne connectant un pôle de la première jonction Josephson (841, 941, 1041, 1141, 1241) à un pôle de l'élément inductif central (843, 943, 1043, 1143, 1243), un deuxième nœud interne connectant un pôle de la deuxième jonction Josephson (842, 942, 1042, 1142, 1242) à un autre pôle de l'élément inductif (843, 943, 1043, 1143, 1243), et un nœud de fermeture de boucle connectant un autre pôle de la première jonction Josephson (801) à un autre pôle de la deuxième jonction Josephson (842, 942, 1042, 1142, 1242),
une première partie circuit (721) connectée entre la masse commune et le premier nœud interne de la boucle (710), et une deuxième partie circuit (722) entre la masse commune et le deuxième nœud interne de la boucle (710), de sorte que ladite première partie circuit (721) et ladite deuxième partie circuit (722) soient mutuellement sensiblement symétriques par rapport audit axe (A), et une troisième partie circuit (723) connectée entre ledit nœud de fermeture de boucle et la masse commune et sensiblement symétrique par rapport audit axe (A),
ledit circuit quantique supraconducteur non linéaire étant configuré de sorte que, lorsqu'un courant prédéterminé d'une intensité constante est appliqué, la fréquence de résonance du deuxième mode soit sensiblement 2N fois la fréquence de résonance du premier mode, une différence de phase est induite à travers les une ou plusieurs jonctions Josephson (841, 941, 1041, 1141, 1241 ; 842, 942, 1042, 1142, 1242), de sorte que le circuit quantique supraconducteur non linéaire présente un Hamiltonien extensible en une somme entre au moins un terme dominant de la forme $\hbar g_{2N} a^{2N} b^\dagger + \hbar g_{2N}^* a^{\dagger 2N} b$ et une série de termes subsidiaires, où $g_{2N}$ est un scalaire correspondant à la force de couplage intrinsèque, $a$ est l'opérateur d'annihilation du premier mode, $b$ est l'opérateur d'annihilation du deuxième mode, et $\hbar$ est la constante de Planck réduite, réalisant ainsi intrinsèquement un échange de 2N-à-1 photons résonants entre respectivement le premier mode et le deuxième mode, N étant un nombre entier positif, ledit circuit quantique supraconducteur non linéaire reposant sur un substrat diélectrique et étant délimité par rapport à un plan de masse commune (820, 920, 1020, 1120, 1220) par des parties exposées dudit substrat diélectrique,

- une ligne de flux (930, 1030, 1130, 1230) située en regard de la partie de ladite au moins une boucle (710) comprenant ledit élément inductif central (843, 943, 1043, 1143, 1243), comprenant une première fente (934, 1034, 1134, 1234), et une partie CPW (932, 1032, 1132, 1232),

ladite partie CPW (932, 1032, 1132, 1232) étant agencée pour être couplée à une source de courant (1012), une source de micro-ondes (914, 1114, 1214) configurée pour appliquer un rayonnement micro-ondes, et une charge (916, 1116, 1216), et étant délimitée par une liaison filaire d'extrémité (938, 1038, 1138, 1238), ladite première fente (934, 1034, 1134, 1234) étant dessinée au sein dudit plan de masse exposant ledit substrat diélectrique, s'étendant sensiblement parallèlement audit axe (A), étant connectée au niveau d'une extrémité à une fente (9320, 10320, 11320, 12320) de ladite partie CPW (932, 1032, 1132, 1232) au niveau de ladite liaison filaire d'extrémité (938, 1038, 1138, 1238), et au niveau de l'autre extrémité à la partie de substrat diélectrique exposée délimitant la partie de ladite au moins une boucle (710) comprenant ledit élément inductif central (843, 943, 1043, 1143, 1243),
ladite ligne de flux (930, 1030, 1130, 1230) étant configurée pour permettre le couplage de ladite source de courant (1012) afin d'induire ledit courant prédéterminé dans ladite au moins une boucle (710), pour permettre le couplage de ladite source de rayonnement micro-ondes (914, 1114, 1214) afin d'induire un entraînement du deuxième mode à une fréquence sensiblement égale à la fréquence de résonance du deuxième mode ou à 2N fois la fréquence de résonance du premier mode, et pour permettre le couplage d'une charge (916, 1116, 1216) sensiblement exclusivement avec ledit deuxième mode.

2. Dispositif quantique selon la revendication 1, dans lequel ladite ligne de flux (930, 1030, 1130, 1230) comprend en outre une deuxième fente (936, 1036, 1136, 1236) dessinée au sein dudit plan de masse exposant ledit substrat diélectrique, s'étendant sensiblement parallèlement audit axe (A), connectée au niveau d'une extrémité à une autre fente (9322, 10322, 11322, 12322) de ladite partie CPW (932, 1032, 1132, 1232) au niveau de ladite liaison filaire d'extrémité (938, 1038, 1138, 1238), et se terminant à l'autre extrémité au sein dudit plan de masse (820, 920, 1020, 1120, 1220) à une distance de ladite partie de ladite au moins une boucle (710) comprenant ledit élément inductif central (843, 943, 1043, 1143, 1243) qui est supérieure à 1 $\mu$m.

3. Dispositif quantique selon la revendication 2, dans lequel ladite deuxième fente (936, 1036, 1136, 1236) comprend une partie de retour (12360) la plus proche de ladite partie de ladite au moins une boucle (710) comprenant ledit élément inductif central (843, 943, 1043, 1143, 1243), ladite partie de retour (12360) s'étendant sensiblement orthogonalement audit axe (A) dans une direction de rotation en s'éloignant de ladite première fente (934, 1034, 1134, 1234).

4. Dispositif quantique selon la revendication 3, dans lequel ladite partie de retour (12360) a une longueur supérieure à 1 $\mu$m et allant jusqu'à la largeur du circuit supraconducteur non linéaire.

5. Dispositif quantique selon l'une des revendications précédentes, dans lequel ladite première fente (934, 1034, 1134, 1234) est sensiblement symétrique par rapport audit axe (A).

6. Dispositif quantique selon l'une des revendications 1 à 4, dans lequel lesdites première fente (934, 1034, 1134, 1234) et deuxième fente (936, 1036, 1136, 1236) sont toutes deux décalées dans une direction orthogonale audit axe (A) et inverse à ladite direction de rotation.

7. Dispositif quantique selon la revendication 6, dans lequel ledit décalage est supérieur à 1 $\mu$m et va jusqu'à la largeur du circuit supraconducteur non linéaire.

8. Dispositif quantique selon l'une des revendications précédentes, dans lequel la longueur de ladite première fente (934, 1034, 1134, 1234) ou alternativement la position de la liaison filaire (938, 1038, 1138, 1238) est choisie en fonction de l'intensité du couplage prévu entre ledit deuxième mode et ladite charge (916, 1116, 1216).

9. Dispositif quantique selon l'une des revendications précédentes, dans lequel le couplage de ladite charge avec ledit deuxième mode est plus de 100 fois supérieur au couplage de ladite charge avec ledit premier mode.

10. Dispositif quantique selon l'une des revendications précédentes, comprenant en outre une source de courant (1012), une source de micro-ondes (914, 1114, 1214) et une charge (916, 1116, 1216) couplées à ladite partie CPW (932, 1032, 1132, 1232) configurées pour stabiliser un collecteur d'états cohérents dans ledit dispositif.

11. Procédé de mesure quantique pour un dispositif selon la revendication 10 comprenant :

a) la modification de la sortie de courant de ladite source de courant de sorte que le courant prédéterminé dans ledit circuit supraconducteur non linéaire induise une fréquence de résonance du deuxième mode sensiblement différente de 2N fois la fréquence de résonance du premier mode,
b) la réalisation d'une mesure quantique sur le premier mode dudit circuit supraconducteur non linéaire.

12. Procédé de mesure quantique selon la revendication 11, dans lequel la modification de l'opération a) est réalisée en appliquant une impulsion carrée audit courant.

13. Procédé de mesure quantique selon la revendication 11 ou 12, dans lequel l'opération b) est une mesure quantique de non-démolition, et comprenant en outre l'opération suivante :
c) la restauration de la sortie de courant de ladite source de courant pour obtenir le courant prédéterminé après que l'opération b) est réalisée.

14. Système informatique quantique comprenant au moins un dispositif selon l'une quelconque des revendications 1 à 10.

FIG. 1

FIG. 2

FIG. 3

$g_2/2\pi = 2.5$ MHz    $K_a/2\pi = 2.6$ MHz

FIG. 4a

$g_2/2\pi = 2.6$ MHz    $K_a/2\pi = 0.0$ MHz

FIG. 4b

FIG. 5

FIG. 6

**FIG. 7**

**FIG. 8a**

**FIG. 8b**

**FIG. 9a**

**FIG. 9b**

**FIG. 10**

**FIG. 11**

1214

1210

1200

1216

1232

12322

1238

12320

1230

1234

1236

1220

12210

12220

1243

1240

1241

1242

A

**FIG. 12**

**FIG. 13**

**FIG. 14**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 21306965

### Non-patent literature cited in the description

- **GAUTIER R. et al.** Combined Dissipative and Hamiltonian Confinement of Cat Qubits. *PRX Quantum*, 2021
- **LESCANNE R.** Exponential suppression of bit-flips in a qubit encoded in an oscillator. *Nature Physics*, 2020
- **TOUZARD S**. Coherent Oscillations inside a Quantum Manifold Stabilized by Dissipation. *Physical Review X*, 2018
- **LEGHTAS Z**. Confining the state of light to a quantum manifold by engineered two-photon loss. *Science*, 2015
- **SUN, L.** ; **PETRENKO, A.** ; **LEGHTAS, Z et al.** Tracking photon jumps with repeated quantum non-demolition parity measurements. *Nature*, 2014, vol. 511, 444-448, https://doi.org/10.1038/nature13436
- **SUN, L.** ; **PETRENKO, A.** ; **LEGHTAS, Z. et al.** Tracking photon jumps with repeated quantum non-demolition parity measurements. *Nature*, 2014, vol. 511, 444-448, https://doi.org/10.1038/nature13436
- **CAMPAGNE-IBARCQ, P.** ; **EICKBUSCH, A.** ; **TOUZARD, S. et al.** Quantum error correction of a qubit encoded in grid states of an oscillator. *Nature*, 2020, vol. 584, 368-372, https://doi.org/10.1038/s41586-020-2603-3
- **S. TOUZARD** ; **A. KOU** ; **N. E. FRATTINI et al.** Gated Conditional Displacement Readout of Superconducting Qubits. *Phys. Rev. Lett.*, vol. 122, 080502